# FASCICULE DE BREVET EUROPEEN

(11) **EP 4 639 189 B1**
(45) Date de publication et mention de la délivrance du brevet: **30.09.2026**
(21) Numéro de dépôt: 23837631.3
(22) Date de dépôt: 21.12.2023
(51) Int. Cl.: G01R 31/367, G01R 31/392, G01R 35/00

(54) **PRÉDICTION DE L'ÉTAT DE SANTÉ D'UN ACCUMULATEUR D'ÉNERGIE ÉLECTRIQUE**
VORHERSAGE DES GESUNDHEITSZUSTANDS EINER BATTERIE
PREDICTING THE STATE OF HEALTH OF A BATTERY

(30) Priorité: 23.12.2022 FR 2214473
(43) Date de publication de la demande: 29.10.2025
(73) Titulaire: Commissariat à l'Energie Atomique et aux Energies Alternatives, 75015 Paris (FR)
(72) Inventeur: VINIT, Laurent, 38054 GRENOBLE (FR); KLEIN, Jean-Marie, 38054 GRENOBLE cedex 09 (FR); MONTARU, Maxime, 38054 GRENOBLE cedex 09 (FR)
(74) Mandataire: INNOV-GROUP
(86) Numéro de dépôt international: PCT/EP2023/087323
(87) Numéro de publication internationale: WO 2024/133725

(56) Documents cités:
- EP-A1- 3 974 853
- WO-A1-2022/136098

## Description

### Domaine technique

L'invention se rapporte à la prédiction de l'état de santé d'un accumulateur d'énergie électrique, notamment un accumulateur Lithium-ion (Li-ion).

Elle trouve des applications, notamment, dans le domaine de la gestion des batteries d'accumulateurs qui assurent le stockage de l'énergie électrique sous forme chimique.

### Etat de la technique antérieure

Les batteries d'accumulateurs d'énergie électrique, qui permettent de stocker de l'énergie électrique selon des procédés électrochimiques réversibles, font actuellement l'objet d'un fort développement. Elles sont utilisées dans différents types d'applications, par exemple pour les véhicules électriques ou hybrides, et au soutien des installations de production d'électricité à partir d'énergies renouvelables (dans les installations photovoltaïques ou éoliennes, par exemple). Les accumulateurs au lithium - dans leurs différentes variantes telles que les batteries « lithium-ion », « lithium-ion-polymère », « lithium-métal-polymère », etc. - sont les batteries présentant une densité d'énergie stockée et une énergie spécifique parmi les plus grandes. Il s'agit donc de la technologie de choix pour le stockage d'énergie électrique dans les applications susmentionnées.

Cependant, il est connu que ces accumulateurs présentent une dégradation de leurs performances au cours du temps. Notamment leur capacité de stockage baisse et leur résistance interne augmente au cours du temps. Ces changements affectent les performances des batteries de stockage d'énergie électrique les incorporant. Or, dans le type d'applications précitées, les impératifs de gestion de la ressource énergétique, tant à la charge qu'à la décharge des batteries, nécessitent la prise en compte fine des mécanismes de dégradation des accumulateurs. Dit autrement, il est nécessaire de prendre en compte l'évolution prévisionnelle des performances des accumulateurs à différents niveaux pour la gestion des systèmes de stockage d'énergie électrique les incorporant (dimensionnement, stratégies de pilotage, maintenance, etc...).

A cet effet, il est connu d'utiliser des modèles d'endurance (l'homme du métier parle aussi de modèles de vieillissement), qui permettent la réalisation de pronostics (on parle aussi de prédictions, ou d'estimations) de l'état de santé d'un accumulateur isolé, et généralement d'une batterie d'accumulateurs opérationnellement agencés au sein d'un système de stockage d'énergie électrique. Ces modèles d'endurance définissent des tables paramétriques (aussi appelées cartographies) indexées par des p-uplets de paramètres (où *p* est un nombre entier strictement supérieur à l'unité). Ces cartographies donnent des valeurs d'éléments qui entrent dans la définition d'un modèle paramétrique, qui modélise la dégradation de la capacité d'un accumulateur, par rapport à ses performances d'origine (c'est-à-dire à l'état neuf), en fonction de paramètres déterminés de son fonctionnement effectif sur le terrain.

Un niveau de performances actualisé des accumulateurs peut ainsi être déterminé grâce à la mise en place d'indicateurs tel que le SOH *(*mis pour « *State-Of-Health »,* en anglais, qui signifie état de santé). Un tel indicateur est calculé ou estimé à partir de valeurs de signaux physiques mémorisés à cette fin dans la mémoire d'un système de gestion de batterie (ou BMS, de l'anglais « *Battery Management System* »)*.* Ces signaux physiques peuvent être mesurés au fil de l'eau directement sur l'accumulateur en cours de fonctionnement, et/ou être estimés à partir de données temporelles de suivi des accumulateurs, comme la tension, le courant, et/ou la température, par exemple. L'évolution prévisionnelle des performances des accumulateurs peut être simulée à tout moment au moyen d'un modèle d'endurance prédéfini, dès lors qu'on connaît les conditions (notamment de température) et le profil des sollicitations auquel il a été soumis depuis l'origine.

Il existe plusieurs types de modèles d'endurance permettant de prédire l'état de santé d'un accumulateur sur la base d'un profil déterminé des paramètres de son fonctionnement au cours d'une période écoulée depuis une certaine référence temporelle, par exemple depuis la fabrication ou la mise en service de l'accumulateur, ou depuis la réalisation d'un diagnostic antérieur. Des modes de réalisation de l'invention considérés dans la présente description à titre purement illustratif, utilisent par exemple un type de modèle bien connu de l'homme du métier, à savoir le modèle empirique proposé dès 2010 par Broussely dans diverses publications scientifiques, par exemple l'article de M. Broussely, S. Herreyre, P. Biensan, P. Kasztejna, K. Nechev, R. Staniewicz, « Aging mechanism in li ion cells and calendar life predictions », Journal of Power Sources, 2001, volume 97, p. 13 - 21. Ce type de modèle est paramétré au moyen d'une base de données constituée de résultats d'essais d'endurance de l'accumulateur, réalisés en laboratoire lors d'une phase d'étude préalable (aussi appelée campagne d'essais d'endurance, ou campagne de vieillissement). Cette base de données peut être plus ou moins étendue en fonction du nombre des essais d'endurance ainsi réalisés. En outre, l'étendue de la campagne d'essais d'endurance est déterminée en fonction du nombre de paramètres de fonctionnement des accumulateurs pouvant influencer les performances de l'accumulateur, qui font l'objet de l'étude.

On distingue classiquement deux modes de dégradation de la capacité des accumulateurs au cours du temps, à savoir :
- la dégradation dite « dégradation calendaire », d'une part : cette dégradation survient constamment au cours de la vie de l'accumulateur, qu'il soit soumis à des sollicitations électriques ou non. Les principaux paramètres influençant la vitesse de cette dégradation sont la température et l'état de charge (ou SOC, de l'anglais « *State-Of-Charge* ») de l'accumulateur ; et,
- la dégradation dite « dégradation de cyclage », d'autre part : cette dégradation survient lorsque l'accumulateur est soumis à une sollicitation électrique, que ce soit en charge ou en décharge. Elle est liée à la quantité de charges électriques (exprimée en Ampères/heure, ou Ah) transitée dans l'accumulateur, en charge ou en décharge. Les principaux paramètres influençant la vitesse de cette dégradation sont la température de fonctionnement, l'état de charge (SOC), le courant de sollicitation, et la profondeur de décharge (ou *DOD,* de l'anglais « *Depth-Of-Discharge* ») aussi appelée plage de SOC (et souvent notée ΔSOC), de l'accumulateur lors de chaque sollicitation électrique.

Une méthode de modélisation empirique de la dégradation d'une batterie consiste à cumuler les effets respectifs de la dégradation calendaire et de la dégradation de cyclage, afin d'obtenir une estimation de la dégradation totale de la capacité de l'accumulateur. A cet effet, les modèles précités peuvent définir des tables paramétriques à deux dimensions en calendaire et à quatre dimensions en cyclage, chacune de ces dimensions correspondant à une valeur d'un des paramètres ci-dessus. Une entrée dans la table est définie par la valeur d'un p-uplet de paramètres (avec p=2 pour la(les) table(s) en calendaire, et p=4 pour la(les) table(s) en cyclage).

On connaît plusieurs publications se rapportant au sujet général de la définition des paramètres d'un modèle de vieillissement des accumulateurs d'énergie électrique, qui sont identifiées et brièvement discutées dans ce qui suit.

Ainsi, l'article de Junfu Lia, Lixin Wang, Chao Lyu, Dafang Wang, et Michael Pecht, intitulé « Parameter updating method of a simplified first principles-thermal coupling model for lithium-ion batteries », Applied Energy V256, décembre 2019 - 113924, présente une méthode de détermination des paramètres sensibles et leur mise à jour. Cette méthode est utilisée afin d'obtenir un indicateur SOC fiable. En effet, le SOC des systèmes peut présenter des aléas de fiabilité au fil du temps et en fonction de l'utilisation des systèmes. Deux méthodes de recalibrage sont décrites : une méthode dite « offline » et une méthode dite « online », mais sont jugées non satisfaisantes. Une combinaison des deux méthodes est également proposée, sous la forme d'un algorithme appelé « *non standard PF algorithm »* par les auteurs. Cet algorithme apparaît néanmoins complexe à mettre en œuvre sur le type de cartographie d'un modèle qui peut être utilisé dans le contexte de la présente invention. Ce type de méthode serait également difficile à mettre en œuvre dans une électronique embarquée avec des microprocesseurs de faibles capacités.

L'article de Biying Ren, Chenxue Xie, Xiangdong Sun, Qi Zhang, et Dan Yan, intitulé « Parameter identification of a lithium-ion battery based on the improved recursive least square algorithm », IET mai 2020, présente quant à lui une méthode de calibration de circuit électrique équivalent de second ordre utilisant un algorithme RLS amélioré. Avec ce type de modèle ainsi qu'avec la méthode de calibration présentée dans ce document, toutefois, il ne s'agit pas d'un recalibrage mais d'une première calibration du modèle.

L'article de Huiyong Chun, Kwanwoong Yoon, Jungsoo Kim, et Soohee Han, intitulé « Improving aging identifiability of lithium-ion batteries using deep reinforcement learning », IEEE TRANSACTIONS ON TRANSFORTATION ELECTRIFICATION 2022, présente une méthode de détermination des paramètres d'un modèle stœchiométrique via une technique d'apprentissage profond par renforcement (« *deep reinforcement learning »,* en anglais) faisant appel aux réseaux de neurones. Là encore, la méthode ainsi présentée ne réalise pas un recalibrage de modèles de vieillissement d'un accumulateur.

Enfin et plus généralement, la plupart des travaux rapportés dans la littérature concernée traitent de la calibration de modèles de performances batterie ou d'indicateurs SOC ou SOH. Or, comme il apparaîtra de la description de modes de réalisation détaillés de l'invention qui seront donnés plus bas, il convient de distinguer la calibration d'un modèle d'endurance, d'un côté, de son recalibrage ou recalage dynamique, d'un autre côté. Pour la calibration, on fait vieillir en laboratoire quelques accumulateurs neufs pendant par exemple 18 mois sous des conditions variées, notamment des conditions d'état de charge (SOC), de courant de sollicitation, et /ou de profondeur de décharge (DOD), et on récupère les données issues du suivi de ces vieillissements permettant de calibrer le modèle de vieillissement pour d'autres accumulateurs similaires qui seront ensuite utilisés en conditions de fonctionnement réel. La recalibration, en revanche, peut être mise en œuvre après une certaine durée de fonctionnement ou de non-fonctionnement de l'accumulateur (c'est-à-dire durant la vie de l'accumulateur). La recalibration suppose qu'on dispose d'un modèle de vieillissement préalablement calibré, qu'on vient mettre à jour à partir du suivi de l'accumulateur dans son application finale.

Le document WO2022136098A1 divulgue un procédé pour estimer la durée de vie d'un système de stockage d'énergie comprenant une pluralité de cellules électrochimiques, consistant à actualiser des paramètres d'un modèle de vieillissement. Plus particulièrement, il est proposé de déterminer un profil thermique et des profils de sollicitation électrique en conditions d'usage à partir des données d'opération, et de simuler le vieillissement du système de stockage en utilisant les paramètres actualisés du modèle vieillissement, d'une part, et des profils thermique et de sollicitation électrique prédéterminés, et les profils thermiques et de sollicitation électrique en conditions d'usage, d'autre part. Dès lors qu'une erreur d'état de santé est supérieure à une valeur seuil, les valeurs de paramètre du modèle sont modifiées.

Le document EP3974853A1, issu des travaux des mêmes inventeurs que la présente demande, divulgue la prédiction du vieillissement futur des cellules d'une batterie par un BMS ("Battery Management System"), consistant à mesurer et mémoriser un profil d'utilisation de la batterie, et à calculer une valeur représentative de l'état de santé futur de la batterie en tenant compte dudit profil d'utilisation mesuré, en se basant sur un modèle prédéfini de vieillissement de la batterie. Cette prédiction incorpore des informations représentatives de l'utilisation effective de la batterie.

Les inventeurs ne connaissent pas d'autre littérature technique traitant de façon détaillée du recalibrage (on peut dire aussi recalage dynamique) des modèles d'endurance du type empirique ou semi-empirique durant la vie d'un accumulateur, pour permettre ensuite la réalisation de pronostics d'état de santé de l'accumulateur sur la base de cartographies actualisées. On entend par « semi-empirique » un modèle d'endurance basé sur l'utilisation d'équations physiques simplifiées dont les paramètres sont identifiés grâce à des données expérimentales obtenues au cours d'essais spécifiques sur la batterie étudiée.

### Exposé de l'invention

La présente invention propose une méthode et des moyens de prédiction de l'état de santé d'un accumulateur d'énergie électrique, notamment mais pas uniquement un accumulateur Li-ion, comprenant un recalibrage des valeurs de la (ou des) cartographie(s) du modèle d'endurance de l'accumulateur durant le fonctionnement de l'accumulateur en situation opérationnelle réelle sur le terrain, lorsqu'un écart entre un pronostic et un diagnostic d'état de santé de l'accumulateur est détecté. On entend par-là l'adaptation dynamique, c'est-à-dire aussi la mise à jour desdites valeurs de cartographie, en réponse à la détection d'un tel écart.

Plus particulièrement, un premier aspect de l'invention concerne un procédé de prédiction de l'état de santé d'un accumulateur d'énergie électrique, notamment une batterie Lithium-ion, comprenant les étapes suivantes, mises en œuvre au cours du fonctionnement de l'accumulateur en situation opérationnelle réelle sur le terrain :
a) simulation de la dégradation de la capacité de l'accumulateur pour produire des données de pronostic de l'état de santé de l'accumulateur sur la base de données physiques issues de la surveillance du fonctionnement de l'accumulateur sur le terrain durant une période de surveillance déterminée, en utilisant un modèle d'endurance rendant compte de l'évolution prévisionnelle des performances de l'accumulateur en fonction du temps écoulé et/ou de l'usage de l'accumulateur depuis sa mise en service sur le terrain, ledit modèle étant déterminé par des valeurs stockées dans une ou plusieurs tables paramétriques qui sont indexées par des valeurs de p-uplets de paramètres de fonctionnement de l'accumulateur et qui sont issues de caractérisations de l'accumulateur préalablement effectuées en laboratoire ;
b) production de données de diagnostic de l'état de santé réel de l'accumulateur, sur la base des données physiques issues de la surveillance du fonctionnement de l'accumulateur sur le terrain durant la période de surveillance ; et,
c) recalibrage d'au moins une des tables paramétriques à l'issue de la période de surveillance considérée, en remplaçant une partie seulement des valeurs de ladite table paramétrique, les valeurs remplacées comprenant les valeurs indexées par les p-uplets de paramètres de fonctionnement sous lesquels l'accumulateur a opéré au moins une fois durant la période de surveillance considérée, lorsqu'un écart entre une valeur représentative de l'état de santé de l'accumulateur estimée à partir des données de pronostic et une valeur représentative de l'état de santé réel de l'accumulateur fondée sur les valeurs de diagnostic est détecté, pour produire une version recalibrée de la table paramétrique.

Ce procédé peut être mis en œuvre à des fins de pilotage et/ou de maintenance de la batterie de stockage d'énergie électrique, et plus généralement de l'installation équipée de cette batterie, dans laquelle l'accumulateur considéré est incorporé. Il trouve des mises en œuvre avantageuses, plus largement, dans toutes applications nécessitant l'utilisation d'un modèle d'endurance d'un ou plusieurs accumulateurs : système de gestion d'énergie (EMS, de l'anglais *« Energy Management System »),* BMS, maintenance prédictive, etc.

Un avantage du procédé est qu'il procure une amélioration substantielle de la précision des prédictions d'état de santé des accumulateurs.

Un autre avantage est qu'il permet la prise en compte de l'environnement réel du système de stockage d'énergie dans les modèles d'endurance des accumulateurs, via les profils d'usage et de température réels issus de données d'opération effective sur le terrain.

En outre, le procédé permet la prise en compte de l'architecture réelle du système de stockage d'énergie électrique installé et en opération effective sur le terrain, au-delà données de laboratoire classiquement utilisées pour réaliser la modélisation du vieillissement des accumulateurs.

Mais le procédé est particulièrement original et avantageux en ce que, en dépit des avantages ci-dessus qu'il procure, il permet de conserver la finesse de la paramétrisation du modèle d'endurance préalablement établi en laboratoire, avec une correction de la (ou des) cartographie(s) qui est ciblée sur les valeurs de ces cartographies réellement utilisées en raison des conditions opérationnelles réelles sur le terrain. La mise à jour des cartographies est minimale. Ceci est particulièrement avantageux dans le contexte d'une mise en œuvre par des moyens électroniques embarqués dans le BMS, qui sont forcément contraints en termes de capacité de mémoire et de puissance de calcul.

Dans un mode de mise en œuvre, le modèle d'endurance comprend au moins deux tables paramétriques, dont une première table paramétrique contient des valeurs rendant compte de la vitesse de dégradation en mode calendaire de la capacité de l'accumulateur, et dont une deuxième table paramétrique contient des valeurs rendant compte de la vitesse de dégradation en mode cyclage de la capacité de l'accumulateur, l'une et/ou l'autre desdites première et deuxième tables paramétriques étant recalibrées à l'étape c).

Dans un mode de mise en œuvre, l'une et/ou l'autre desdites première et deuxième tables paramétriques sont recalibrées à l'étape c) par calcul, via la multiplication de valeurs à remplacer par un coefficient de recalibrage.

Dans un mode de mise en œuvre, le coefficient de recalibrage est identique pour toutes les valeurs remplacées dans l'une des cartographies recalibrées parmi la première et la deuxième cartographie et étant également identique, le cas échéant, pour le remplacement de valeurs dans l'une et dans l'autre desdites première et deuxième tables paramétriques recalibrées.

Dans un mode de mise en œuvre, le coefficient de recalibrage est un nombre scalaire calculé comme le ratio entre la valeur représentative de l'état de santé réel de l'accumulateur fondée sur les valeurs de diagnostic sur la valeur représentative de l'état de santé de l'accumulateur estimée à partir des données de pronostic.

Dans un mode de mise en œuvre, le modèle d'endurance comprend en outre deux autres tables paramétriques, dont une troisième table paramétrique contient des valeurs rendant compte du facteur de forme de la dégradation en mode calendaire de la capacité de l'accumulateur, et dont une quatrième table paramétrique contient des valeurs rendant compte du facteur de forme de la dégradation en mode cyclage de la capacité de l'accumulateur, l'une et/ou l'autre desdites troisième et quatrième tables paramétriques étant recalibrées, à l'étape c), par une méthode d'optimisation adaptée pour minimiser l'écart entre les données de diagnostic et les données de pronostic.

Dans un mode de mise en œuvre, le recalibrage d'une table paramétrique pour produire une table paramétrique recalibrée à l'étape c) comprend le remplacement non seulement des valeurs indexées par les p-uplets de paramètres de fonctionnement de l'accumulateur dans lesquels l'accumulateur a été utilisé au moins une fois durant la période d'observation, mais également le remplacement des valeurs de la table paramétrique qui sont voisines desdites valeurs indexées par lesdits p-uplets de paramètres de fonctionnement de l'accumulateur, en utilisant une fonction de lissage déterminée.

Dans un mode de mise en œuvre, le recalibrage d'une table paramétrique pour produire une table paramétrique recalibrée n'est effectué, à l'étape c), que si la valeur du coefficient de recalibrage diffère de l'unité d'une valeur de différence qui est supérieure à un seuil de valeur déterminé.

Dans un mode de mise en œuvre, les étapes a) à c) sont répétées itérativement, avec une récurrence fixe ou variable, à l'issue de périodes de surveillance respectives successives.

Dans un mode de mise en œuvre, la récurrence des recalibrages est variable, avec une variabilité indéterminée qui est liée à au moins un paramètre de fonctionnement donné de l'accumulateur.

Dans un mode de mise en œuvre, dans lequel les données de diagnostic sont basées, en outre, sur des données physiques additionnelles qui sont issues de surveillances, effectuées *in situ* ou *ex situ,* d'autres accumulateurs du même type que l'accumulateur considéré.

Dans des modes de mise en œuvre, le procédé peut comprendre en outre, après l'étape c), une étape de comparaison des données de diagnostic avec de nouvelles données de diagnostic obtenues en utilisant la ou les cartographies recalibrées à l'étape c) pour, en cas de persistance d'un écart entre une valeur représentative de l'état de santé de l'accumulateur estimée à partir des données de pronostic et une valeur représentative de l'état de santé réel de l'accumulateur fondée sur les valeurs de diagnostic, décider le recalibrage d'autres tables paramétriques et/ou de renouveler le recalibrage de la ou des tables paramétriques sur la base de données de surveillance plus étendues, comprenant des données additionnelles fondées sur l'observation d'autres accumulateurs du même type que l'accumulateur considéré.

Un deuxième aspect de l'invention concerne un dispositif de prédiction de l'état de santé d'un accumulateur d'énergie électrique, par exemple un système de gestion d'une batterie d'accumulateurs d'énergie électrique, comprenant des moyens pour la mise en œuvre du procédé selon le premier aspect ci-dessus.

Un troisième aspect de l'invention concerne une installation de stockage d'énergie électrique comprenant une batterie d'accumulateurs électriques ayant une pluralité d'accumulateurs d'énergie électrique, et un dispositif de gestion de la batterie comprenant un dispositif de prédiction de l'état de santé d'un accumulateur d'énergie électrique selon le deuxième aspect ci-dessus.

Enfin, un quatrième et dernier aspect de l'invention concerne un produit programme d'ordinateur comprenant des instructions qui, lorsque le programme est chargé dans la mémoire et exécutée par un calculateur d'un ordinateur, met en œuvre toutes les étapes du procédé selon le premier aspect tel que défini plus haut.

### Description des dessins

D'autres aspects, caractéristiques et avantages de l'invention apparaîtront encore à la lecture de la description qui va suivre. Celle-ci est purement illustrative et doit être lue en regard des dessins annexés dans lesquels on a représenté :

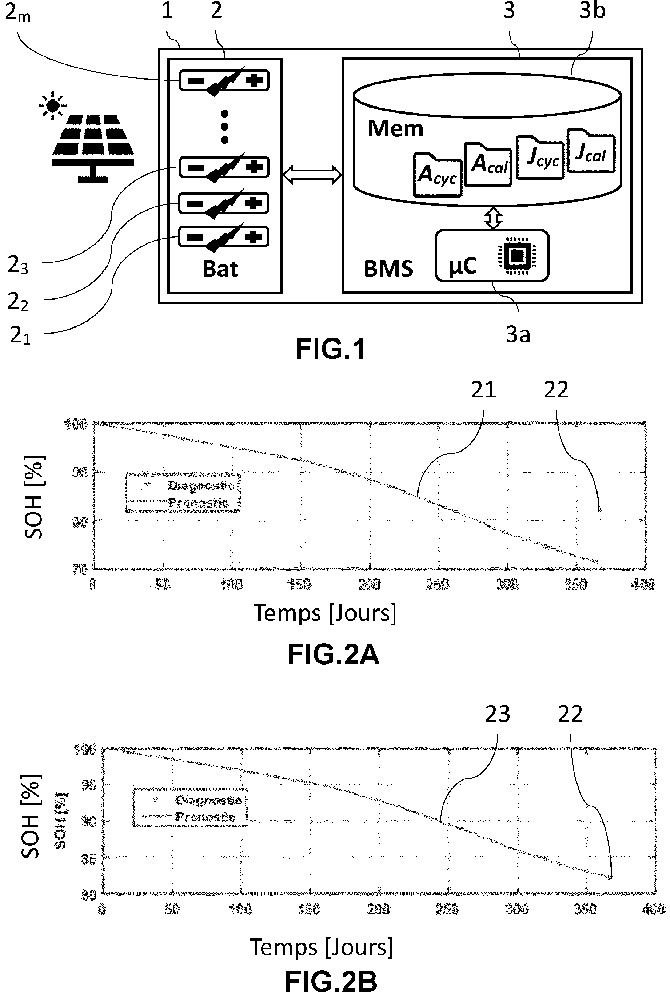

[Fig. 1] un schéma fonctionnel simplifié d'un système de stockage d'énergie électrique dans lequel des modes de mise en œuvre de l'invention peuvent être implémentés ;
[Fig. 2A] un graphe illustrant l'écart entre les données de pronostic et une donnée de diagnostic à l'issue d'une durée de surveillance d'une année, d'un accumulateur d'un système de stockage d'énergie tel que celui de la figure 1, en cours de fonctionnement opérationnel dudit système sur le terrain ;
[Fig. 2B] un graphe correspondant au graphe de la figure 2A après recalibrage, sur la base de la donnée de diagnostic, de la cartographie de la vitesse de dégradation en mode calendaire et de la cartographie de la vitesse de dégradation en mode cyclique du modèle d'endurance de l'accumulateur considéré du système de stockage d'énergie électrique, et recalcul des données de pronostic sur la base des cartographies ainsi recalibrées ;

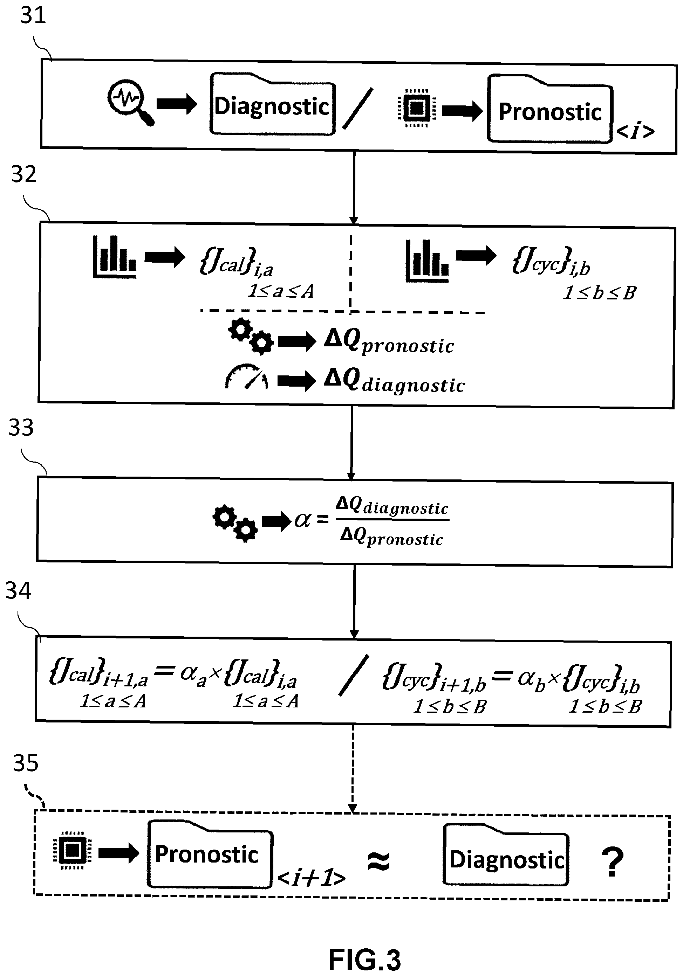

[Fig. 3] un diagramme d'étapes illustrant les principales étapes de modes de mise en œuvre du procédé selon l'invention ;

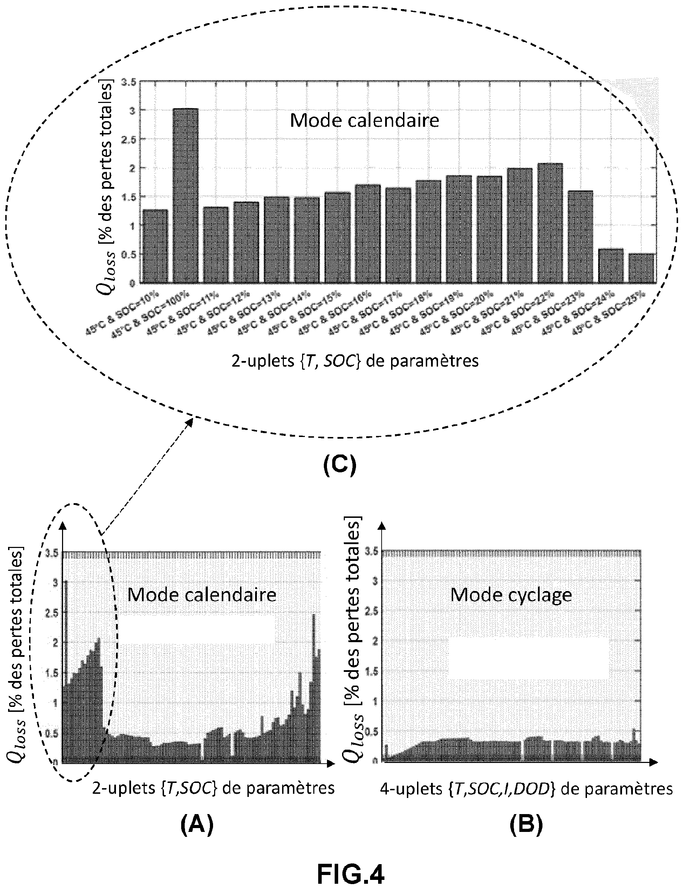

[Fig. 4] un ensemble de trois graphes illustrant les résultats de classification des dégradations liées au calendaire et au cyclage de la capacité de stockage d'un accumulateur, qui ont été causées par l'utilisation d'un accumulateur avec des p-uplets de paramètres de fonctionnement déterminés, lesquels p-uplets de paramètres de fonctionnement ont été constatés par la surveillance du système de stockage d'énergie en conditions opérationnelles effectives sur le terrain ;

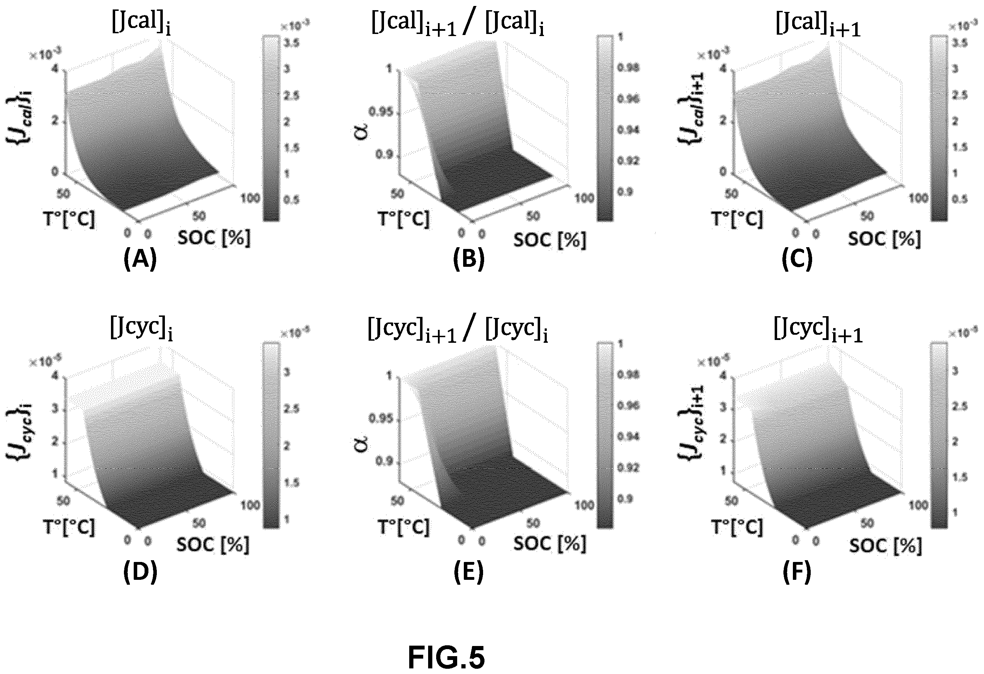

[Fig. 5] deux ensembles de trois graphes chacun, qui sont disposés en ligne et qui illustrent chacun, pour la vitesse de dégradation liée au calendaire sur la ligne du haut et pour la vitesse de dégradation liée au cyclage sur la ligne du bas, respectivement, la cartographie avant recalibrage, le coefficient de recalibrage, et la cartographie recalibrée, respectivement à gauche, au centre et à droite de la ligne correspondante ; et,

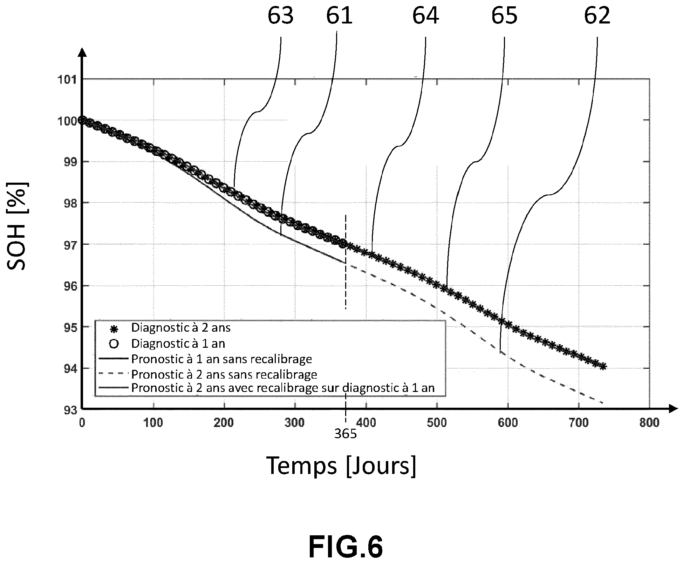

[Fig. 6] un graphe illustrant l'effet bénéfique, au cours d'une deuxième année d'utilisation d'un accumulateur sur le terrain, d'un recalibrage effectué selon des modes de mise en oeuvre de l'invention à l'issue d'une première année d'utilisation de l'accumulateur.

### Description des modes de réalisation

Dans une installation de stockage d'énergie électrique, une batterie d'accumulateurs permet de stocker de l'énergie électrique sous forme chimique et de la restituer ensuite sous forme de courant continu, de manière contrôlée. Dans des secteurs comme l'éolien ou le photovoltaïque, les batteries d'accumulateurs sont utilisées pour stocker de façon temporaire l'énergie produite en excès par rapport à la demande de courant électrique par l'équipement (ou les équipements) et/ou dans le(s) réseau(x) de distribution de courant alimenté(s) par la batterie, et pour, en intermittence, la restituer en période de plus forte demande de courant. Ainsi par exemple, les batteries utilisées dans les fermes solaires sont des batteries optimisées pour un fonctionnement avec des panneaux photovoltaïques produisant de l'énergie électrique grâce à l'énergie solaire.

En référence à la figure 1 un système de stockage d'énergie électrique 1 comprend une batterie 2 d'accumulateurs 2₁, 2₂, 2₃, ... 2ₘ, par exemple des accumulateurs Li-ion, qui sont autant de cellules élémentaires de stockage d'énergie électrique. Les cellules 2₁, 2₂, 2₃, ... 2ₘ sont connectées entre elles en série et/ou en parallèle.

Le système 1 comprend en outre un dispositif électronique 3, formant système de gestion de la batterie (BMS), qui est adapté pour piloter les cellules (accumulateurs) 2₁, 2₂, 2₃, ... 2ₘ de la batterie 2. Le dispositif 3 comprend *a minima* un calculateur électronique 3a, par exemple un microprocesseur ou un microcontrôleur, et une mémoire électronique 3b associée, comprenant par exemple de la mémoire vive et de la mémoire permanente. Le calculateur 3a et la mémoire associée 3b sont de technologies adaptées à, et de capacités dimensionnées pour l'utilisation pour laquelle ils sont prévus.

Le dispositif 3 peut être configuré, de manière générale, pour mettre en oeuvre des fonctions diverses du système de stockage d'énergie électrique incorporant l'accumulateur considéré, et d'autres. Ces fonctions peuvent comprendre, de façon non limitative, des fonctions d'équilibrage des cellules, des fonctions de protection, des fonctions de calcul de l'état de charge et/ou de l'état de santé présent des cellules de la batterie, des fonctions de maintenance prédictive, etc.

A cet effet, le système 1 comprend également divers capteurs (non représentés sur la figure), qui sont adaptés notamment pour produire des mesures à partir desquelles le dispositif génère des données de diagnostic reflétant l'état de santé réel de chacun des accumulateurs de la batterie 2. Ces mesures physiques concernent notamment les paramètres de fonctionnement des accumulateurs et du système 1 en général, comme la température de fonctionnement par exemple. Ces mesures sont effectuées au fil de l'eau, dans le cadre de la surveillance du fonctionnement des accumulateurs sur le terrain. Les données ainsi produites durant une période de fonctionnement déterminée sont stockées dans la mémoire 3b du dispositif 3.

A titre d'exemple non limitatif, l'homme du métier appréciera que le dispositif électronique 3 peut comprendre un ou plusieurs capteurs de tension et/ou un ou plusieurs capteurs de courant adaptés à mesurer des tensions et/ou des courants entre les bornes de cellules élémentaires et/ou de groupes de cellules élémentaires de la batterie connectées en série et/ou en parallèle. Le dispositif 3 peut en outre comporter un ou plusieurs capteurs de température.

Dans le contexte et pour les besoins de la mise en oeuvre de l'invention, on peut aussi stocker dans la mémoire 3b les données de diagnostic de l'état de santé des accumulateurs qui ont été générées depuis le début de l'utilisation opérationnelle des accumulateurs, ou bien depuis une opération de recalibrage précédente, en cas de réalisation d'une série d'opérations de recalibrage avec une récurrence fixe ou variable.

En outre, le dispositif 3 est adapté pour la mise en œuvre des étapes du procédé de traitement des données mesurées par les capteurs. Dans le cadre de cette mise en œuvre, le calculateur 3a exécute un produit programme d'ordinateur, *i.e.,* un logiciel comprenant des instructions adaptées pour la mise en œuvre du procédé de prédiction objet du premier aspect de l'invention. Plus spécifiquement, lorsqu'il est chargé dans la mémoire 3b et est exécuté par le calculateur 3a du dispositif 3, ce logiciel exécute toutes les étapes du procédé selon des modes de mise en œuvre proposés dans la présente description.

Une formulation possible du modèle empirique peut s'écrire via les équations de vieillissement (1), (2) et (3) suivantes, sur la base des travaux de Grolleau *et al.* en 2014 (voir notamment l'article Grolleau Sébastien, Delaille Arnaud, Gualous Hamid, Gyan Philippe, Revel Renaud, Bernard Julien, Redondo-Iglesias Eduardo et Peter Jérémy, « Calendar Aging of Commercial Graphite/LiFePO4 Cell: Predicting Capacity Fade under Time Dependent Storage Conditions », Journal of Power Sources [En ligne], 2014, volume 255, p. 450-458. Mis en ligne le 11/12/2013.
DOI :10.1016/j.jpowsour.2013.11.098) : $\frac{\partial {Q}_{loss}}{\partial t} = \frac{{J}_{cal} \left(T, SOC\right)}{1 + Acal . {Q}_{loss}}$ $\frac{\partial {Q}_{loss}}{\partial {Q}_{th}} = {J}_{cyc} \left(T, SOC, I, DOD\right) ⋅ {\left(1+Acyc.{Q}_{loss}\right)}^{γ}$ ${dQ}_{loss} = \frac{\partial {Q}_{loss}}{\partial t} dt + \frac{\partial {Q}_{loss}}{\partial {Q}_{th}} {dQ}_{th}$

Dans les équations (1), (2) et (3) ci-dessus :
- *Qₗₒₛₛ* désigne la capacité de stockage de l'accumulateur perdue, exprimée en Ampères-heures (Ah), par rapport à sa capacité nominale d'origine (par exemple à l'état neuf de l'accumulateur) ;
- *J_{cal}* désigne la vitesse de dégradation de l'accumulateur liée au calendaire, exprimée en Ampères-heures par seconde (Ah.s⁻¹) ;
- *J_{cyc}* désigne la vitesse de dégradation de l'accumulateur liée au cyclage, exprimée en Ampères-heures perdu « par » Ampère-heure transité (Ah.Ah⁻¹) ;
- *Qₜₕ* désigne la capacité transitée dans l'accumulateur (en charge ou en décharge), exprimée en Ampères-heures (Ah) ;
- t désigne la durée de la période de temps considérée (de fonctionnement ou de non-fonctionnement de l'accumulateur), exprimée en secondes (s) ;
- T désigne la température de l'accumulateur, exprimée en degrés Celsius (°C) ;
- SOC désigne l'état de charge de l'accumulateur, exprimé en pourcentage (%) de la charge nominale d'un accumulateur neuf ;
- / désigne le courant de sollicitation de l'accumulateur exprimé en Ampères (A) ;
- DOD désigne la profondeur de décharge exprimée en pourcentage (%) de la charge nominale d'un accumulateur neuf ;
- *A_{cal}* désigne le facteur de forme de la dégradation de l'accumulateur liée au calendaire, exprimé en Ampères/heure (Ah⁻¹) ;
- *A_{cyc}* désigne le facteur de forme de la dégradation de l'accumulateur liée au cyclage, exprimé en Ampères/heure (Ah⁻¹) ; et, enfin,
- *γ* est un scalaire dont la valeur est 1 ou -1.

L'équation (1) permet de déterminer les pertes de capacité de l'accumulateur liées au mode de vieillissement calendaire. Ces pertes dépendent principalement de deux facteurs, à savoir la température (T°) et l'état de charge (SOC). L'équation (2) permet de déterminer les pertes de capacité liées au mode de vieillissement cyclage. Ces pertes sont occasionnées par chaque sollicitation de l'accumulateur. Elles dépendent principalement de la température (T°) et de l'état de charge (SOC) de l'accumulateur au moment de la sollicitation, ainsi que du niveau de sollicitation en courant (*l*) et de la profondeur de décharge (*DOD*) correspondant à la sollicitation. Enfin l'équation (3) permet de déterminer les pertes de capacité totales, qui sont obtenues selon cette équation en cumulant les pertes liées au mode calendaire et les pertes liées au mode cyclage.

La calibration d'un modèle d'endurance empirique tel que celui présenté ci-dessus est une étape qui permet, par simulations successives du modèle et mise en regard des résultats de mesures expérimentales du SOH, d'optimiser les valeurs des tables paramétriques donnant *J_{cal}, A_{cal}, J_{cyc}* et *A_{cyc}* en fonction à chaque fois des p-uplets de paramètres qui indexent ces cartographies. Les simulations sont réalisées au moyen de profils de tests issus de caractérisations de l'accumulateur effectuées en laboratoire. Le plan de caractérisation de l'accumulateur et ses résultats sont donc connus au moment où la calibration du modèle est réalisée. Le plan de caractérisation de l'accumulateur comporte plusieurs conditions d'essais différentes réalisées en laboratoire sur plusieurs accumulateurs ayant la même référence, c'est-à-dire des accumulateurs du même modèle de fabrication, ainsi que la mesure expérimentale des variations de SOH qui en résultent.

Dans un exemple, le plan de caractérisation de la vitesse de vieillissement liée au calendaire d'un accumulateur de référence donnée, peut être obtenu sur la base d'une matrice de 9 conditions, correspondant par exemple aux 9 combinaisons possibles de 3 valeurs de la température (T°) et 3 valeurs de l'état de charge (SOC). Ces conditions d'utilisation sont appliquées chacune à l'une parmi 9 cellules indépendantes respectives, ayant la même référence de fabrication. Ces cellules sont ainsi opérées, de manière contrôlée, et sont surveillées pendant une campagne de vieillissement en laboratoire qui dure par exemple 18 mois ou 2 ans. Pour réaliser ensuite l'optimisation du modèle sur la base des données des profils de test ainsi obtenus, on peut utiliser un logiciel de simulation tel que MATLAB^{™} ou tout autre logiciel équivalent.

Ainsi, par exemple, on obtient la composante de *Qₗₒₛₛ* correspondant aux pertes de capacité liées au mode calendaire en faisant tourner le logiciel de simulation pour le modèle défini plus haut, que l'on optimise par comparaisons successives avec les données réelles des profils de test obtenus, dont les estimations expérimentales de ladite composante *Qₗₒₛₛ*, pour les valeurs de *J_{cal}* et *A_{cal}.*

De la même façon, on obtient la composante de *Qₗₒₛₛ* correspondant aux pertes de capacité liées au mode cyclage à partir des données réelles des profils de test pour les valeurs de *J_{cyc}* et *A_{cyc}*, en faisant des comparaisons successives entre les données prédites par le modèle en cours d'optimisation et les données réelles des profils de caractérisation dont l'estimation expérimentale de ladite composante *Qₗₒₛₛ*, et ce aux mêmes valeurs de la capacité *Qₜₕ* transitée dans chacun des accumulateurs testés. On peut avantageusement retirer l'effet du mode de vieillissement calendaire progressivement accumulé sur la période de test, par simple soustraction, afin de modéliser la composante des pertes liées au mode cyclage avec plus de précision.

L'homme du métier appréciera que l'invention n'est pas limitée par l'exemple de modèle empirique d'endurance de l'accumulateur explicité dans ce qui précède, ni par la méthode de calibration décrite ci-dessus, ni par la méthodologie suivie pour obtenir les profils de tests qui sont utilisés pour effectuer cette calibration. En particulier, l'invention est également compatible avec l'utilisation de tout autre modèle d'endurance. Elle est également compatible avec l'utilisation d'une pluralité de modèles d'endurance différents, respectivement associés, par exemple, à des accumulateurs de types différents qui peuvent être simultanément utilisés au sein du même système de stockage d'énergie électrique, au lieu d'un modèle unique associé à des accumulateurs du même type (*i.e.,* ayant la même référence de fabrication). Dans un tel cas, le procédé peut être mise en œuvre parallèlement pour les différents accumulateurs sur la base de leurs modèles d'endurance respectifs.

Dans un exemple de mise en œuvre reposant sur le modèle de vieillissement considéré ici :
- les valeurs de la cartographie [Jcal] donnant la vitesse *J_{cal}* et/ou les valeurs de la cartographie [Acal] donnant le facteur de forme *A_{cal},* respectivement, de la dégradation de la capacité de l'accumulateur liée au mode calendaire, sont indexées par les 2-uplets de paramètres *{T°,SOC}ₐ*, où l'indice a est compris entre 1 et un nombre entier A qui est strictement supérieur à l'unité. Ce nombre A définit le nombre maximum de couples de paramètres de fonctionnement de l'accumulateur qui sont pris en compte pour la mise en œuvre du procédé. Il s'agit des 2-uplets de paramètres *{T°,SOC}* auquel l'accumulateur a été soumis au moins une fois dans le cadre de son fonctionnement effectif sur le terrain pendant la période de surveillance considérée ; et/ou,
- les valeurs de la cartographie [Jcyc] donnant la vitesse *J_{cyc}* et/ou les valeurs de la cartographie [Acyc] donnant le facteur de forme *A_{cyc},* respectivement, de la dégradation de la capacité de l'accumulateur liée au cyclage, sont indexées par les 4-uplets de paramètres *{T°,SOC,I,DOD}_{b},* où l'indice b est compris entre 1 et un nombre entier *B* qui est strictement supérieur à l'unité. Ce nombre entier *B* définit le nombre maximum de quadruplets de paramètres de fonctionnement de l'accumulateur pris en compte dans le procédé. Il s'agit des 4-uplets de paramètres *{T°,SOC,I,DOD}* auquel l'accumulateur a été soumis au moins une fois dans le cadre de son fonctionnement effectif sur le terrain pendant la période de surveillance considérée.

Là encore, il est bien évident que l'invention n'entend pas être restreinte à ces exemples, qui sont purement illustratifs de modes de mises en œuvre possibles mais non limitatifs du procédé de prédiction selon l'invention.

Le principe à la base du procédé de prédiction de l'état de santé d'un accumulateur selon des mises en œuvre de l'invention réside dans une mise à jour (ou recalibrage, ou encore recalage) optimisée des cartographies de modèles paramétriques d'endurance (ou modèles de vieillissement), lorsqu'il est détecté un écart entre le pronostic d'état de santé (SOH) obtenu en utilisant ces cartographies, d'une part, et le diagnostic d'état de santé du même accumulateur issu de données de surveillance du fonctionnement effectif (sur le terrain) de l'accumulateur produites et mémorisées nativement dans le BMS qui est embarqué dans le système de stockage, d'autre part.

Dans certaines réalisations, notamment dans les installations équipées de batteries comprenant une pluralité de cellules, proches ou distantes, qui sont connectées entre elles et/ou dont la gestion est mutualisée, on peut aussi utiliser des données de diagnostic plus étendues, basées en outre sur des données physiques additionnelles qui sont issues de surveillances d'autres accumulateurs du même type (*i.e.,* ayant la même référence de fabrication) effectuées *in situ* ou *ex situ.* Ces données physiques additionnelles peuvent être récupérées par le calculateur 31 implémentant la méthode, par tous moyens de communication appropriés sur lesquels il n'apparaît pas utile de s'étendre ici : réseau de données filaires, par exemple réseau Ethernet et/ou réseau de données sans fil, utilisant par exemple les technologies de communication longue distance comme la 3G-LTE, la 4G ou la 5G et/ou des technologies de communication sans fil à faible distance comme le NFC, le Bluetooth, le Wi-Fi, etc.

Selon le principe du procédé proposé, la mise à jour des cartographies est améliorée par rapport à l'art antérieur en ce que toutes les valeurs des cartographies ne sont pas modifiées à l'occasion du recalibrage des cartographies selon les mises en oeuvre de l'invention. Au contraire, seules sont modifiées les valeurs des cartographies donnant *J_{cal}, J_{cyc}, A_{cal}* et/ou *A_{cyc}* pour des *p*-uplets déterminés de paramètres de fonctionnement de l'accumulateur (*p*-uplets par lesquels ces cartographies sont indexées). Il s'agit des valeurs qui ont été effectivement utilisées en étant lues dans les cartographies correspondantes via les *p*-uplets de paramètres de fonctionnement opérés au moins une fois durant l'utilisation considérée de l'accumulateur, pour produire les données de pronostic qui, dans l'exemple considéré ici, sont représentées par la courbe 21 de la figure 2A. On entend par là que, pour chaque cartographie, on modifie seulement les valeurs de la cartographie dans les zones de fonctionnement de l'accumulateur définie par les *p*-uplets de paramètres de fonctionnement qui ont été effectivement constatés au moins une fois sur le terrain, c'est-à-dire aussi les valeurs de la cartographie indexées par tous les *p*-uplets de paramètres dans lesquels l'accumulateur a été utilisé au moins une fois pendant la période de temps de fonctionnement considérée, et seulement ces valeurs-là.

Le graphe de la figure 2A donne la valeur d'un indicateur de l'état de santé (SOH), à savoir la capacité résiduelle de l'accumulateur à l'instant *t*, exprimée en pourcentage de la capacité nominale de l'accumulateur au début de sa vie. Plus particulièrement, le graphe de la figure 2A illustre l'écart entre les données de pronostic représentées par la courbe 21 et une donnée de diagnostic à l'issue d'une durée de surveillance d'une année (soit 365 jours) représentée par le point 22, pour un accumulateur d'un système de stockage d'énergie tel que celui de la figure 1. La courbe 21 représente donc une fonction décroissante en fonction du temps t écoulé. La donnée de diagnostic 22 est générée à partir des données de diagnostic accumulée durant la surveillance continue de l'accumulateur en situation opérationnelle effective, sur le terrain, du système de stockage d'énergie électrique l'incorporant.

Comme on peut le constater, le point 22 est au-dessus de la courbe 21 à *t =* 265 jours. Ceci montre que le modèle défini par les équations (1), (2) et (3) et les cartographies [Jcal], [Acal], [Jcyc] et [Acyc] s'avère trop pessimiste, en ce sens que l'état de santé (SOH) de l'accumulateur prédit par ce modèle et reflété par la courbe 21 de la figure 2A est en-deçà de la valeur effectivement diagnostiquée au bout d'un an (*i.e., à t =* 365 jours) et reflété par le point 22.

Plus particulièrement, on voit que la valeur de l'écart est un peu supérieure à 10% de SOH, puisque la valeur de diagnostic 22 est égale à 82 %, alors que la prédiction à 365 jours donnée par la courbe 21 correspond à environ une valeur comprise entre 71% et 72%. Cet écart est suffisamment significatif pour justifier un recalibrage des cartographies. En effet, la tolérance sur la précision des prédictions n'est que de l'ordre de 2 à 3% d'erreur.

Le graphe de la figure 2B correspond au graphe de la figure 2A mais après recalibrage, sur la base de la donnée de diagnostic 22, de la cartographie de la vitesse de dégradation en mode calendaire [Jcal] et de la cartographie de la vitesse de dégradation en mode cyclique [Jcyc] du modèle d'endurance de l'accumulateur du système de stockage d'énergie électrique qui est considéré ici. Sur ce graphe, la courbe 23 représente les prédictions de l'état de santé (SOH) en fonction du temps écoulé, c'est-à-dire les données de pronostic qui peuvent être obtenues sur la base des cartographies recalibrées selon des mises en oeuvre du procédé de l'invention. On voit que, à l'issue de la période d'observation considérée, soit à *t* = 365 jours, la courbe 23 représentative des valeurs prédites (pronostic) coïncide maintenant avec la valeur réellement constatée (diagnostic). Ceci traduit l'efficacité du procédé. En effet, cela signifie que les pronostics fournis par le modèle défini par les cartographies recalibrées sont bien calés avec le diagnostic disponible à la date considérée.

En référence au diagramme d'étapes de la figure 3, on va maintenant décrire les principales étapes de modes de mise en oeuvre du procédé, qui permettent d'obtenir un tel résultat. C'est en effet la mise en oeuvre de ces étapes qui a permis d'obtenir les résultats présentés ci-dessus en référence à la figure 2B.

A l'étape 31 du procédé, le calculateur 3a récupère les données de diagnostic obtenues par la surveillance (« *monitoring* » en anglais) du fonctionnement opérationnel effectif de l'accumulateur durant la période considérée (et le cas échéant des données de diagnostic additionnelles, comme exposé plus haut, obtenues pour d'autres accumulateurs du même type, qui sont opérés *in situ* ou *ex situ*)*.*

Le calculateur 3a récupère aussi les valeurs des paramètres de fonctionnement opérationnel effectif sur le terrain de l'accumulateur, à savoir *T°*, *SOC, I* et *DOD,* qui entrent dans la composition des *p*-uplets de paramètres indexant les tables paramétriques (cartographies) à partir desquelles les valeurs de pronostic de la dégradation de la capacité de l'accumulateur peuvent être calculées. Toutes ces données ont été stockées au fil du temps dans la mémoire 3b, durant la période de surveillance de l'accumulateur concerné. Il suffit donc de les lire dans la mémoire 3b. Le cas échéant, les paramètres des données de diagnostic additionnelles peuvent être récupérés de la même manière que lesdites données additionnelles en elles-mêmes.

A l'étape 32, on sélectionne des *p*-uplets de paramètres indexant les cartographies [Jcal] et [Jcyc], sur la base des conditions de fonctionnement réel de l'accumulateur pendant la période de surveillance considérée. On recense ainsi :
- un nombre A de couples de paramètres *{T°,SOC}ₐ*, où l'indice a est compris entre 1 et A, indexant la cartographie [Jcal] de la vitesse de dégradation en mode calendaire ; ainsi que
- un nombre B de quadruplets de paramètres *{T°,SOC,I,DOD}_{b},* où l'indice b est compris entre 1 et B, indexant la cartographie [Jcyc] de la vitesse de dégradation en mode cyclique.
En outre, le calculateur 3a effectue, à partir des données de pronostic, le calcul de la contribution calendaire et de la contribution de cyclage à la valeur prédite *ΔQ_{pronostic}* de la dégradation de la capacité de l'accumulateur sur la période considérée, en utilisant les équations (1) et (2), respectivement, du modèle d'endurance empirique.

Ces calculs sont effectués à partir des éléments (termes et facteurs) de ces équations et dont les valeurs sont lues dans les cartographies [Jcal] et [Acal] et dans les cartographies [Jcyc] et [Acyc], respectivement. A cet effet, l'accès aux cartographies [Jcal] et [Acal] et aux cartographies [Jcyc] et [Acyc] est réalisé via les 2-uplets *{T°,SOC}ₐ* pour a compris entre 1 et A et via les 4-uplets *{T°,SOC,I,DOD}_{b}* pour b compris entre 1 et B, respectivement, qui ont été préalablement sélectionnés. On rappelle que ces nombres A et *B* correspondent au nombre total de couples et au nombre total de quadruplets, respectivement, de valeurs des paramètres de fonctionnement de l'accumulateur qui ont été effectivement constatés durant la période de surveillance considérée. Ces *p*-uplets de paramètres et les valeurs correspondantes des pertes *Qₗₒₛₛ* données par les équations (1) et (2) à partir des valeurs indexées par ces *p*-uplets dans les cartographies [Jcal] et [Acal] et dans les cartographies [Jcyc] et [Acyc], sont représentées par les diagrammes (A) et (C) ainsi que par le diagramme (B), respectivement, de la figure 4, laquelle sera décrite en détail plus loin.

Bien entendu, la valeur prédite *ΔQ_{pronostic}* de la dégradation de la capacité de l'accumulateur sur la période considérée est ensuite obtenue en sommant les deux contributions (calendaire et cyclage), conformément à l'équation (3) du modèle d'endurance empirique considéré ici. Bien que la prise en compte des deux contributions simultanément ne soit pas une obligation absolue, elle est toutefois préférée car elle donne des résultats meilleurs, qui rendent mieux compte de la réalité des phénomènes de dégradation de la capacité de l'accumulateur au cours du temps et en fonction de son utilisation.

En outre, toujours à l'étape 32, on évalue la valeur *ΔQ_{diagnostic}* de la perte de capacité de l'accumulateur constatée à l'instant *t* auquel le diagnostic de l'état de l'accumulateur est réalisé.

L'étape 33 comprend l'obtention d'un coefficient de correction *α*, également appelé coefficient de recalibrage car il sert à recalibrer les cartographies pour réduire l'écart entre les données de pronostic et les données de diagnostic. L'homme du métier appréciera que le coefficient de recalibrage *α* est un scalaire. Son utilisation en tant que facteur multiplicatif pour le recalibrage des cartographies (cf. étapes 34 décrite ci-dessous) est donc avantageuse, étant donné qu'elle n'exige pas de puissance de calcul très importante (comparé à une multiplication matricielle, par exemple).

Dans un mode de mise en oeuvre tel qu'illustré à la figure 3, l'étape 33 est réalisée par calcul. Plus particulièrement, le coefficient de recalibrage *α* est un ratio scalaire obtenu en divisant la valeur *ΔQ_{diagnostic}* par la valeur *ΔQ_{pronostic}.* On rappelle que la valeur *ΔQ_{diagnostic}* désigne la perte de capacité de l'accumulateur constatée à l'instant *t* auquel le diagnostic de l'état de l'accumulateur est réalisé. La valeur *ΔQ_{pronostic}*, déjà mentionnée plus haut, désigne la perte de capacité globale de l'accumulateur qui est prédite à l'instant *t* considéré, sur la base du modèle cartographique, c'est-à-dire le cumul (*i.e.,* la somme) des valeurs de perte de capacité données par l'équation (3) sur la base des valeurs lues dans les tables paramétriques (cartographies) pour les *p*-uplets de paramètres sous lesquels l'accumulateur a été utilisé jusqu'à l'instant *t*.

Cette mise en oeuvre de l'étape 33 par calcul donne de bons résultats et, avantageusement, elle est relativement rapide. Elle peut néanmoins être remplacée, à titre d'alternative optionnelle, par une étape d'obtention du coefficient *α* par optimisation, ce qui constitue une des variantes possibles à la méthode de recalibrage des cartographies selon le procédé proposé. La détermination par une méthode d'optimisation est plus fine, mais plus lente et demande plus de capacité de calcul. Le principe de la détermination des valeurs des paramètres par optimisation consiste en effet à réaliser des simulations successives du modèle, et à comparer les résultats des pronostics à la valeur de diagnostic *ΔQ_{diagnostic}* afin de minimiser l'écart entre la valeur *ΔQ_{diagnostic}* obtenue simulation et cette valeur de diagnostic *ΔQ_{diagnostic}* obtenues en conditions réelles. Pour cela, on peut utiliser une méthode d'optimisation telle que, par exemple, la méthode des moindres carrés. On peut aussi utiliser une méthode alternative basée sur l'implémentation d'un réseau de neurones. Cette variante donne de meilleurs résultats, encore, que la méthode par calcul, mais nécessite une puissance de traitement plus importante et une capacité mémoire plus élevée, au niveau du dispositif électronique 30.

On notera que le coefficient de recalibrage *α* est le même pour l'ensemble des *p-*uplets de paramètres, et ce tant pour le mode calendaire que pour le mode cyclage. En effet, le diagnostic ne donne pas d'indication sur la répartition des dégradations individuellement constatées pour le mode cyclage et pour le mode calendaire, respectivement. Il n'est donc pas possible de dissocier leurs effets au travers de coefficients de correction/recalibrage respectifs.

L'étape 34 du procédé comprend l'application du facteur de correction *α* aux valeurs des cartographies de départ, à recalibrer, qui sont repérées chacune à la figure et dans ce qui suit par l'indice « *i* », afin d'obtenir les valeurs des cartographies recalibrées, repérées chacune à la figure et dans ce qui suit par l'indice « *i+1* ». Comme déjà mentionné plus haut, cette mise à jour des cartographies consiste à multiplier par le scalaire *α* les valeurs concernées des cartographies de départ (valeurs repérées par l'indice « *i* »), afin d'obtenir les valeurs de la cartographie recalibrée (valeurs repérées par l'indice « *i+1* »).

Avantageusement, le coefficient de recalibrage *α* est identique pour toutes les valeurs qui sont remplacées au sein de chaque cartographie qui est recalibrée. Ceci a l'avantage de la simplicité. Et il a pu être constaté que cela donne de bons résultats en pratique.

Dans le mode de mise en oeuvre tel qu'illustré à la figure 3, on se contente de mettre à jour :
- les *A* valeurs *{J_{cal}}_{i,a},* pour a compris entre 1 et A, de la cartographie [Jcal] donnant la vitesse de dégradation liée au mode calendaire et correspondant au nombre A de couples de paramètres {*T°,SOC*}*ₐ* sous lesquels l'accumulateur a opéré au moins une fois durant la période de surveillance considérée; et/ou
- les *B* valeurs *{J_{cyc}}_{i,b}*, pour b compris entre 1 et B, de la cartographie [Jcyc] donnant la vitesse de dégradation liée au mode cyclage et correspondant au nombre *B* de quadruplets de paramètres *{T°,SOC,I,DOD}_{b}* sous lesquels l'accumulateur a opéré au moins une fois durant la période de surveillance considérée.

En effet, il a été constaté que ce sont ces deux éléments de l'équation (3) du modèle d'endurance empirique qui contribuent le plus à un écart entre les données de pronostic et les données de diagnostic. Il est donc suffisant, dans certaines applications, de se limiter à la mise à jour des deux cartographies [Jcal] et [Jcyc]. On restreint ainsi la complexité de la mise en oeuvre du procédé, en réduisant de ce fait également le coût de calcul auquel le dispositif électronique 30 est exposé.

Rien n'empêche, toutefois, de prévoir des modes de mise en oeuvre dans lesquels on recalibrerait, en outre, l'une et/ou l'autre des deux cartographies [Acal] et [Acyc] qui donnent les valeurs du facteur de forme des dégradations de la capacité de l'accumulateur. Dans ces modes de réalisation, on mettrait ainsi également à jour, en outre :
- les A valeurs *{A_{cal}}_{i,a}* pour a compris entre 1 et A, de la cartographie [Acal] donnant le facteur de forme de la dégradation liée au mode calendaire ; et/ou,
- les B valeurs *{A_{cyc}}_{i,b}* pour b compris entre 1 et B, de la cartographie [Acyc] donnant le facteur de forme de la dégradation liée au mode cyclage.
Le coefficient de recalibrage utilisé, le cas échéant, pour les remplacements de valeurs effectués dans chacune des cartographies [Acal] et [Acyc] est noté *β*. Il diffère du coefficient de recalibrage *α* pour les cartographies [Jcal] et [Jcyc]. Le coefficient de recalibrage *β* peut toutefois être obtenu, le cas échéant, de la même manière que le coefficient de recalibrage *α*, à savoir en appliquant la méthode qui a été décrite dans ce qui précède en référence au diagramme d'étapes de la figure 3, mais à partir des valeurs *{A_{cal}}ᵢ* et des valeurs *{A_{cyc}}ᵢ.*au lieu des valeurs *{J_{cal}}ᵢ* et des valeurs *{J_{cyc}}ᵢ,* respectivement.

Le fait de recalibrer l'une seulement, plusieurs, voire la totalité des différentes tables paramétriques [Jcal], [Acal], [Jcyc] et [Acyc] du modèle d'endurance considéré, permet de graduer la prise en compte de la dégradation spécifiquement provoquée par chacun des éléments des équations (1), (2) et (3) qui déterminent le modèle empirique de la dégradation de la capacité de l'accumulateur. Ceci permet d'instaurer, si besoin, un « ordre de priorité » et/ou un « niveau d'importance » (ou poids) respectif au recalibrage des différentes tables paramétriques entrant chacune dans la composition des éléments du modèle d'endurance.

Le cas échéant, la cartographie [Acal] et la cartographie [Acyc] sont recalibrées, à l'étape 34, de préférence par une méthode d'optimisation. Une telle méthode est adaptée pour minimiser l'écart entre les données de diagnostic et les données de pronostic. Il a en effet été constaté qu'une méthode d'optimisation présente une meilleure efficacité pour la mise à jour de valeurs de facteur de forme de la dégradation de la capacité de l'accumulateur. Il peut s'agir, par exemple, de la méthode des moindres carrés, ou de toute autre méthode comparable que l'homme du métier peut considérer sur la base de ses connaissances générales dans le domaine technique en cause.

Dans des modes de réalisation, on peut cumuler les avantages respectifs d'une méthode calculatoire relativement rapide *(i.e.,* méthode d'obtention d'un coefficient de recalibrage par calculs, telle que par exemple la méthode décrite dans ce qui précède pour le ratio *α*) et d'une méthode par optimisation relativement plus précise. Ainsi par exemple, une méthode par optimisation permettant de corriger les cartographies [Acal] et [Acyc] du facteur de forme de la dégradation en mode calendaire et en mode cyclique, respectivement, peut être mise en oeuvre si la correction préalable des cartographies [Jcal] et [Jcyc] de la vitesse de dégradation en mode calendaire et en mode cyclique, respectivement, via le coefficient de recalibrage *α* obtenu par une méthode calculatoire n'est pas suffisante. Autrement dit, dans ces modes de réalisation, on réalise d'abord une correction sur les cartographies [Jcal] et [Jcyc] directement via le coefficient de recalibrage *α*, puis on réalise dans un second temps une correction par optimisation sur les cartographies [Acal] et [Acyc]. Cela permet d'effectuer dans un premier temps une correction grossière mais rapide sur les vitesses de la dégradation de la capacité de l'accumulateur dans chacun des modes calendaire et cyclique, puis le cas échéant d'affiner ensuite la correction ainsi obtenue par une méthode d'optimisation plus lente sur les facteurs de forme desdites dégradations.

Par ailleurs, dans une autre variante possible, on peut appliquer à l'étape 34 le facteur de correction également aux valeurs stockées dans les cartographies correspondant à des paramètres non utilisés, mais qui sont voisines de valeurs correspondant à des paramètres utilisés et qui ont été mises à jour. Ceci permet notamment d'apporter une solution aux éventuelles discontinuités que pourrait présenter la cartographie après recalibrage, pour des valeurs correspondant à un ou plusieurs *p-*uplets de paramètres isolés. En effet, de telles discontinuités peuvent ensuite donner lieu à des résultats de simulation empreints de singularités pouvant produire des effets aberrants, par exemple des sauts dans les pronostics d'état de santé qui ne seraient pas représentatifs d'une évolution réelle de l'état de santé de l'accumulateur.

L'homme du métier, sur la base de ses connaissances générales dans le domaine du traitement de données numériques et notamment de données dans des tables paramétriques, saura identifier et mettre en oeuvre une relation de voisinage dans une telle table, liant des valeurs à modifier autour d'une valeur déterminée de la table. Il saura aussi identifier et utiliser une fonction de lissage des valeurs autour d'une valeur isolée qui est modifiée dans une telle table, afin de réduire les discontinuités que cette modification peut engendrer. On peut citer à titre d'exemple la loi de distribution normale en fonction de la température, dans laquelle on considère la température du *p*-uplet et dans laquelle l'écart-type peut être fixé à 5°C par exemple.

Nonobstant la variante de mise en oeuvre ci-dessus, et quelle(s) que soi(en)t la (ou les) cartographie(s) mise(s) à jour, on notera que le recalibrage d'au moins une des tables paramétriques à l'issue de la période de surveillance considérée est effectué en remplaçant une partie seulement des valeurs de ladite table paramétrique. Les valeurs remplacées comprennent les valeurs *{Jcal,}_{i,a}* et *{Jcyc,}_{i,b}* indexées par les 2-uplets de paramètres de fonctionnement *{T°,SOC}ₐ* et par les 4-uplets de paramètres de fonctionnement *{T°,SOC,I,DOD}_{b},* respectivement, sous lesquels l'accumulateur a opéré au moins une fois durant la période de surveillance considérée. La mise à jour de la (ou des) cartographie(s) est minimale, ce qui est avantageux en termes de capacité de mémoire et de puissance de calcul requis. Le caractère partiel de la mise à jour de la (ou des) table(s) paramétrique(s) permet en outre de conserver la finesse de la paramétrisation du modèle d'endurance préalablement établi en laboratoire, avec une correction de la (ou des) cartographie(s) qui est ciblée sur, voire limitée aux valeurs de ces cartographies réellement utilisées dans le contexte des conditions opérationnelles réelles sur le terrain.

On rappelle que les remplacements de valeurs dans la (ou les) cartographie(s) sont effectués pour produire une version recalibrée de la (ou des) table(s) paramétrique(s) correspondante(s) lorsqu'un écart entre une valeur représentative de l'état de santé *ΔQ_{pronostic}* de l'accumulateur estimée à partir des données de pronostic et une valeur représentative de l'état de santé réel *ΔQ_{diagnostic}* de l'accumulateur fondée sur les valeurs de diagnostic est détecté. Dans un mode de mise en œuvre possible, le recalibrage d'une cartographie pour produire une cartographie recalibrée n'est effectué, à l'étape 34, que si en outre l'écart qui est détecté entre la valeur *ΔQ_{pronostic}* représentative de l'état de santé pronostiquée en utilisant le modèle d'endurance et la valeur représentative de l'état de santé réel de l'accumulateur *ΔQ_{diagnostic},* est considéré comme suffisant pour justifier un recalibrage des cartographies. Avantageusement, cette condition peut être appréciée en comparant la valeur du coefficient de recalibrage *α* à un seuil de valeur déterminé *αₜₕ* Le coefficient de recalibrage *α* étant, dans des modes de réalisation, un scalaire dont la valeur « neutre » est égale à l'unité (c'est-à-dire à 1), ceci peut être réalisé, par exemple, par calcul de la manière suivante :
- si une distance entre *α* et l'unité, définie par exemple comme la valeur absolue de leur différence, est strictement supérieure à *αₜₕ* (c'est-à-dire si |1-*α*| *> αₜₕ*), le recalibrage est effectué ; alors que,
- si la distance entre *α* et l'unité, telle que définie par exemple comme indiqué ci-dessus, est inférieure ou égale à *αₜₕ* (c'est-à-dire si |1-*α*| *= < αₜₕ*)*,* le recalibrage n'est pas effectué.

Dans le cas décrit, le coefficient de recalibrage *α* est un nombre scalaire calculé comme le ratio entre la valeur représentative de l'état de santé réel *ΔQ_{diagnostic}* de l'accumulateur fondée sur les valeurs de diagnostic sur la valeur représentative de l'état de santé *ΔQ_{pronostic}* de l'accumulateur estimée à partir des données de pronostic. L'invention n'est pas limitée à l'utilisation de la distance indiquée ci-dessus. Toute autre distance peut être utilisée, selon la topologie de l'ensemble des valeurs du coefficient de recalibrage. Par exemple, si le coefficient de recalibrage *α* est un vecteur, on peut utiliser la distance de la norme 1 (ou distance des valeurs absolues), la distance de la norme 2 (ou distance euclidienne), ou encore la distance de la norme 3 (ou distance uniforme), par exemple, définie à chaque fois sur l'ensemble des valeurs de *α*. Dans un exemple de mise en œuvre, en outre, le seuil *αₜₕ* peut être fixé en considération de la marge d'incertitude (ou tolérance) sur la précision des prédictions qui peut être admise pour l'application concernée. En effet, on peut considérer qu'il n'est pas utile de recalibrer les cartographies des éléments du modèle empirique si l'écart constaté entre le pronostic donné par ce modèle et le diagnostic réalisé sur la base des données réelles est inférieur à cette tolérance. En pratique, la tolérance ou marge d'erreur admise étant de l'ordre de 2 à 3%, on peut fixer le seuil *αₜₕ à* 3% en valeur relative (c'est-à-dire que *αₜₕ =* 0,03 dans l'exemple donné au paragraphe ci-dessus), par exemple, voire à 4 ou 5%.

Cette mise en œuvre présente l'avantage de l'économie des calculs à réaliser pour obtenir l'effet de seuillage recherché, le cas échéant.

L'homme du métier appréciera que d'autres modes de mise en œuvre peuvent être considérés pour obtenir un tel effet de seuillage, par exemple en comparant l'écart entre la valeur *ΔQ_{pronostic}* représentative de l'état de santé qui a été pronostiquée en utilisant le modèle d'endurance, d'une part, et la valeur *ΔQ_{diagnostic}* représentative de l'état de santé de l'accumulateur qui a été réellement constatée, d'autre part.

Dans une autre mise en œuvre possible, les étapes 31 à 34 sont répétées itérativement, avec une récurrence fixe ou variable, à l'issue de périodes de surveillance de l'accumulateur respectives successives. Dit autrement, le procédé est mis en œuvre en tant que processus itératif, chaque itération permettant de recalibrer, si nécessaire tout ou partie des cartographies. La récurrence des éventuels recalibrages peut être fixe, par exemple semestrielle, annuelle, biannuelle, etc. Elle peut également être variable, par exemple avec une variabilité prédéterminée selon un calendrier fixant des dates de recalibrages, ou avec une variabilité indéterminée qui peut par exemple être liée à un (ou plusieurs) paramètres) de fonctionnement donné(s)de l'accumulateur, tel que la température moyenne, maximale ou minimale (éventuellement pendant des périodes de temps déterminées), ou tel que le niveau des sollicitations de l'accumulateur durant la période d'observation. Dans ce dernier cas, le niveau des sollicitations de l'accumulateur peut être déterminé sur la base de la capacité transitée dans l'accumulateur (*Qₜₕ*)*,* du nombre de dépassements d'une valeur seuil déterminée par le courant de sollicitation (1) et/ou par la profondeur de décharge (DOD), etc.

L'étape 35, qui est optionnelle, peut être mise en œuvre pour vérifier l'efficience du recalibrage effectué. Cette étape consiste à comparer des nouvelles données de diagnostic (repérées à la figure 3 par l'indice *i+1* à l'étape 35) qui ont été recalculées en utilisant les cartographies telles qu'elles ont éventuellement été recalibrées à l'étape 34, aux données de diagnostic utilisées pour décider de procéder à ce recalibrage au vu des données de pronostic initiales (repérées à la figure 3 par l'indice *i* à l'étape 31), d'une part, et pour recalibrer les cartographies, d'autre part. Cette vérification peut révéler une insuffisance ou une imperfection du recalibrage en cas de persistance d'une écart entre les données de pronostic et les données de diagnostic, et conduire à décider d'étendre le recalibrage à d'autres cartographies (quand, par exemple, toutes les cartographies [Jcal], [Acal], [Jcyc] et [Acyc] n'ont pas été recalibrées) et/ou de renouveler sur calibrage sur la base de données de surveillance plus étendues (notamment avec des données additionnelles fondées sur l'observation d'autres accumulateurs du même type, comme il a été évoqué dans ce qui précède à titre d'option possible).

La figure 4 montre un ensemble de trois graphes illustrant les résultats de classification des dégradations liées au calendaire et au cyclage de la capacité de stockage d'un accumulateur, qui ont été causées par l'utilisation d'un accumulateur avec des p-uplets de paramètres de fonctionnement déterminés, lesquels p-uplets de paramètres de fonctionnement ont été constatés par la surveillance du système de stockage d'énergie en conditions opérationnelles effectives sur le terrain.

Plus particulièrement, le graphe [A] de la figure 4 donne les valeurs élémentaires de la dégradation en mode calendaire qui ont été causées par l'utilisation de l'accumulateur avec des couples (2-uplets) de paramètres de fonctionnement *{T°,SOC}ₐ*, pour *a* compris en 1 et A. Ce graphe montre la répartition des dégradations élémentaires en mode calendaire, en % de la dégradation totale pronostiquée par le modèle d'endurance, en fonction des couples de paramètres de la cartographie [Jcal] de la vitesse de dégradation en mode calendaire. Le graphe (C) de la figure 4 est un zoom du graphe (A) sur les premiers couples de paramètres *{T°,SOC}ₐ*. De la même manière, le graphe (B) de la figure 4 montre la répartition des dégradations élémentaires en mode cyclage, en % de la dégradation totale pronostiquée par le modèle d'endurance, en fonction des quadruplets de paramètres *{T°,SOC,I,DOD}_{b},* pour *b* compris en 1 et *B* de la cartographie [Jcyc] de la vitesse de dégradation en mode cyclage.

La figure 5 montre deux ensembles de trois graphes, qui sont disposés chacun en lignes respectives. Les graphes (A) et (C) de la ligne du haut illustrent, pour la vitesse de dégradation liée au mode calendaire : la cartographie [Jcal]ᵢ avant recalibrage, et la cartographie recalibrée [Jcal]_{*i*+*1*}, respectivement à gauche et à droite de la ligne. La cartographie présentée au centre de la ligne du haut par le graphe (B) représente le ratio de la cartographie recalibrée [Jcal]_{*i*+*1*} sur la cartographie [Jcal]*ᵢ* avant recalibrage. Le rapport de deux matrices étant une matrice, on obtient donc bien une cartographie à trois dimensions notée « [Jcal]_{*i*+*1*} / [Jcal]*ᵢ* » en titre du graphe (B), pour les valeurs de ratio *{Jcal}ᵢ₊₁* / *{Jcal}ᵢ.* Cette cartographie rend compte de l'effet du coefficient *α* dans la toute la gamme de paramétrage de la cartographie [Jcal], ce qui permet de mettre en évidence les zones affectées par le recalibrage. De la même manière, les graphes (D) et (F) de la ligne du bas illustrent, pour la vitesse de dégradation liée au mode cyclage : la cartographie [Jcyc]*ᵢ* avant recalibrage et la cartographie recalibrée [Jcyc]_{*i*+*1*}, respectivement à gauche et à droite de la ligne. La cartographie présentée au centre de la ligne du bas par le graphe (E) représente le ratio de la cartographie recalibrée [Jcyc]_{*i*+*1*} sur la cartographie [Jcyc]*ᵢ* avant recalibrage. Cette cartographie, notée « [Jcyc]_{*i*+*1*} / [Jcyc]*ᵢ* » en titre du graphe (E) rend compte de l'effet du coefficient de recalibrage *α* dans la toute la gamme de paramétrage de la cartographie [Jcyc]. On notera que les graphes (D), (E) et (F) n'illustrent que les valeurs de cartographies pour les paramètres T° et SOC correspondant à la température et à l'état de charge, respectivement, et non les quadruplets de paramètres *{T°,SOC,I,DOD}.* Ceci donne une meilleure lisibilité de ces graphes. En outre, cela est justifié par le fait que, en pratique, la vitesse de dégradation liée au mode cyclique s'est avérée peu dépendante du régime (paramètre *I*) et de la profondeur de décharge (paramètre *DOD*).

En considérant les graphes (B) et (E), on s'aperçoit tout d'abord qu'ils sont identiques. Ceci illustre l'identité du coefficient de recalibrage appliqué pour la mise à jour de chaque valeur modifiée dans la cartographie [Jcal] et dans la cartographie [Jcyc], qui a déjà été mentionnée plus haut.

On remarque ensuite que les valeurs du coefficient de recalibrage *α* sont toutes inférieures à l'unité, en étant plus particulièrement comprises entre 0,9 et 1. Ceci traduit l'effet du recalibrage des cartographies qui, dans l'exemple considéré ici, consiste à diminuer la valeur des éléments des équations de vieillissement (1) et (2) du modèle d'endurance utilisé, sachant que la valeur de la dégradation de la capacité de l'accumulateur évolue dans le même sens que ces éléments. Or, comme il a été mentionné plus haut en référence au graphe de la figure 2A, dans l'exemple considéré ici, le modèle défini par (notamment) les cartographies [Jcal] et [Jcyc] de la vitesse de dégradation s'avère pessimiste en ce sens que l'état de santé (SOH) de l'accumulateur prédit par ce modèle et reflété par la courbe 21 de la figure 2A est en-deçà de la valeur effectivement diagnostiquée au bout d'un an (*i.e.,* à *t* = 365 jours) et reflété par le point 22 sur la figure 2A. C'est pourquoi il est logique que le recalibrage effectué selon l'invention ait pour effet de réduire les valeurs des éléments des équations (1) et (2) du modèle empirique, afin que les prédictions concernant l'état de santé de l'accumulateur obtenues avec les cartographies recalibrées [Jcal]_{*i*+*1*} et [Jcyc]_{*i*+*1*} soient relevées par rapport à celles antérieurement obtenues avec les cartographies précédentes [Jcal]*ᵢ* et [Jcyc]*ᵢ*.

Enfin et surtout, on observe que les cartographies [Jcal]ᵢ et [Jcyc]ᵢ n'ont pas été entièrement modifiées : dans cet exemple en effet, seules ont été corrigées les valeurs des tables dans les zones des paramètres SOC et température, qui ont été sélectionnées à l'étape 32 du diagramme de la Figure 3.

Le graphe de la figure 6 illustre l'effet bénéfique, au cours d'une deuxième année d'utilisation d'un accumulateur sur le terrain, d'un recalibrage effectué selon des modes de mise en œuvre de l'invention à l'issue d'une première année d'utilisation de l'accumulateur.

Sur le graphe, les courbes suivantes sont représentées :
- la courbe 61 (en trait continu mince/faible) et la courbe 62 (en trait discontinu) illustrent l'évolution du SOH sur une période de 1 an et sur une période de 2 ans, respectivement, sur base de pronostics sur ces période respectives, et établies dans les deux cas sur la base des cartographies sans recalibrage (c'est-à-dire, sans la mise en œuvre de l'invention). Ces courbes se superposent bien entendu entre *t* =0 et *t* = 365 jours ;
- la courbe 63 (courbes de petits ronds) et la courbe 64 (courbes de d'étoiles) illustrent l'évolution du SOH sur une période de 1 an et sur une période de 2 ans, respectivement, en fonction des diagnostics constatés durant ces périodes respectives. Ces courbes se superposent bien entendu entre *t* =0 et *t* = 365 jours ;
- La courbe 65 (en trait continu épais/fort) illustre l'évolution du SOH sur une période de 2 ans établie sur la base des cartographies (pronostic) avec un recalibrage effectué à *t =* 365 jours au moyen des données de diagnostic accumulées sur la période de 1 an précédente (c'est-à-dire, avec la mise en œuvre de l'invention).

Comme l'homme du métier le comprend au vu de ces courbes, en observant que la courbe 65 coïncide avec la courbe 63 entre *t* =0 et *t =* 365 jours et également avec la courbe 64 au-delà de *t* = 365 jours, le recalibrage effectué à 1 an permet d'améliorer les valeur de pronostic de l'état de santé de l'accumulateur produits sur toute la période suivante, en l'occurrence la période comprise entre 1 an et 2 ans dans l'exemple illustré, par rapport aux valeurs qui seraient pronostiquées sans la mise en œuvre de l'invention et le recalibrage effectué, dans l'exemple considéré ici, concernant les cartographies [Jcal] et [Jcyc] à l'issue d'une période d'observation de 1 an. Cet exemple a bien entendu une portée de valeur générale, n'étant donné ici qu'à titre de simple illustration d'un des avantages de l'invention.

Avantageusement, le procédé peut être réalisé, selon certains modes de mise en oeuvre, sur la base de et/ou pour plusieurs accumulateurs ou groupes d'accumulateurs identiques (des accumulateurs identiques étant des accumulateurs ayant la même référence de fabrication, ou des accumulateurs qui sont en tous points comparables et techniquement substituables les uns aux autres), qui opèrent suivant des profils d'utilisation terrain différents. En effet, un modèle d'endurance et les cartographies associées étant propres à une référence d'accumulateur, ceci permet de bénéficier pour l'implémentation du procédé d'une agrégation de données de diagnostic, et ainsi d'obtenir un meilleur recalibrage. Le recalibrage est meilleur en ce qu'il est basé sur des données de diagnostic qui sont plus nombreuses, donc statistiquement plus significatives en moyenne, et/ou en ce qu'il couvre des plages d'utilisation de l'accumulateur qui sont plus étendues, par exemple des plages de température correspondant à la superposition de plages de températures respectives qui sont potentiellement différentes les unes des autres.

La présente invention a été décrite et illustrée dans la présente description détaillée et dans les figures des dessins annexés, dans des formes de réalisation possibles. La présente invention ne se limite pas, toutefois, aux formes de réalisation présentées. D'autres variantes et modes de réalisation peuvent être déduits et mis en oeuvre par la personne du métier à la lecture de la présente description et des dessins annexés.

Dans les revendications, le terme "comprendre" ou "comporter" n'exclut pas d'autres éléments ou d'autres étapes. Un seul processeur ou plusieurs autres unités peuvent être utilisées pour mettre en oeuvre l'invention. Les différentes caractéristiques présentées et/ou revendiquées peuvent être avantageusement combinées. Leur présence dans la description ou dans des revendications dépendantes différentes, n'excluent pas cette possibilité. Les signes de référence ne sauraient être compris comme limitant la portée de l'invention.

## Revendications

1. Procédé de prédiction de l'état de santé d'un accumulateur d'énergie électrique, notamment une batterie Lithium-ion, comprenant les étapes suivantes, mises en oeuvre au cours du fonctionnement de l'accumulateur en situation opérationnelle réelle sur le terrain :
a) simulation (32) de la dégradation de la capacité de l'accumulateur pour produire des données de pronostic de l'état de santé de l'accumulateur sur la base de données physiques issues de la surveillance (31) du fonctionnement de l'accumulateur sur le terrain durant une période de surveillance déterminée, en utilisant un modèle d'endurance rendant compte de l'évolution prévisionnelle des performances de l'accumulateur en fonction du temps écoulé et/ou de l'usage de l'accumulateur depuis sa mise en service sur le terrain, ledit modèle étant déterminé par des valeurs stockées dans une ou plusieurs tables paramétriques ([Jcal], [Acal], [Jcyc], [Acyc]) qui sont indexées par des valeurs de p-uplets de paramètres de fonctionnement de l'accumulateur et qui sont issues de caractérisations de l'accumulateur préalablement effectuées en laboratoire ;
b) production (31) de données de diagnostic de l'état de santé réel de l'accumulateur, sur la base des données physiques issues de la surveillance (31) du fonctionnement de l'accumulateur sur le terrain durant la période de surveillance ; et,
c) recalibrage (33,34) d'au moins une des tables paramétriques à l'issue de la période de surveillance considérée, en remplaçant une partie seulement des valeurs de ladite table paramétrique, les valeurs remplacées comprenant les valeurs (*{Jcal,}*_{i,a} *; {Jcyc,}_{i,b}*) indexées par les *p*-uplets de paramètres de fonctionnement sous lesquels l'accumulateur a opéré au moins une fois durant la période de surveillance considérée, lorsqu'un écart entre une valeur représentative de l'état de santé (*ΔQ_{pronostic}*) de l'accumulateur estimée à partir des données de pronostic et une valeur représentative de l'état de santé réel (*ΔQ_{diagnostic}*) de l'accumulateur fondée sur les valeurs de diagnostic est détecté, pour produire une version recalibrée de la table paramétrique.

2. Procédé selon la revendication 1, dans lequel le modèle d'endurance comprend au moins deux tables paramétriques ([Jcal] ; [Jcyc]), dont une première table paramétrique ([Jcal]) contient des valeurs rendant compte de la vitesse de dégradation en mode calendaire de la capacité de l'accumulateur, et dont une deuxième table paramétrique ([Jcyc]) contient des valeurs rendant compte de la vitesse de dégradation en mode cyclage de la capacité de l'accumulateur, l'une et/ou l'autre desdites première et deuxième tables paramétriques étant recalibrées à l'étape c).

3. Procédé selon la revendication 2, dans lequel l'une et/ou l'autre desdites première et deuxième tables paramétriques sont recalibrées à l'étape c) par calcul, via la multiplication de valeurs à remplacer (*{Jcal,}_{i,a} ; {Jcyc,}_{i,b}*) par un coefficient de recalibrage (*α*).

4. Procédé selon la revendication 3, dans lequel le coefficient de recalibrage est identique pour toutes les valeurs remplacées dans l'une des cartographies recalibrées parmi la première et la deuxième cartographie et étant également identique, le cas échéant, pour le remplacement de valeurs dans l'une et dans l'autre desdites première et deuxième tables paramétriques recalibrées.

5. Procédé selon l'une quelconque des revendications 2 à 4, dans lequel le coefficient de recalibrage (*α*) est un nombre scalaire calculé comme le ratio entre la valeur représentative de l'état de santé réel (*ΔQ_{diagnostic}*) de l'accumulateur fondée sur les valeurs de diagnostic sur la valeur représentative de l'état de santé (*ΔQ_{pronostic}*) de l'accumulateur estimée à partir des données de pronostic.

6. Procédé selon l'une quelconque des revendications 2 à 5, dans lequel le modèle d'endurance comprend en outre deux autres tables paramétriques ([Acal] ; [Acyc]), dont une troisième table paramétrique ([Acal]) contient des valeurs rendant compte du facteur de forme de la dégradation en mode calendaire de la capacité de l'accumulateur, et dont une quatrième table paramétrique ([Acyc]) contient des valeurs rendant compte du facteur de forme de la dégradation en mode cyclage de la capacité de l'accumulateur, l'une et/ou l'autre desdites troisième et quatrième tables paramétriques étant recalibrées, à l'étape c), par une méthode d'optimisation adaptée pour minimiser l'écart entre les données de diagnostic et les données de pronostic.

7. Procédé selon l'une quelconque des revendications 1 à 6, dans lequel le recalibrage d'une table paramétrique pour produire une table paramétrique recalibrée à l'étape c) comprend le remplacement non seulement des valeurs (*{Jcal,}_{i,a} ; {Jcyc,}_{i,b}*) indexées par les p-uplets de paramètres de fonctionnement de l'accumulateur dans lesquels l'accumulateur a été utilisé au moins une fois durant la période d'observation, mais également le remplacement des valeurs de la table paramétrique qui sont voisines desdites valeurs indexées par lesdits *p*-uplets de paramètres de fonctionnement de l'accumulateur, en utilisant une fonction de lissage déterminée.

8. Procédé selon l'une quelconque des revendications 1 à 7, dans lequel le recalibrage d'une table paramétrique pour produire une table paramétrique recalibrée n'est effectué, à l'étape c), que si la valeur du coefficient de recalibrage (*α*) diffère de l'unité d'une valeur de différence qui est supérieure à un seuil de valeur déterminé (*αₜₕ*)*.*

9. Procédé selon l'une quelconque des revendications 1 à 8, dans lequel les étapes a) à c) sont répétées itérativement, avec une récurrence fixe ou variable, à l'issue de périodes de surveillance respectives successives.

10. Procédé selon la revendication 9, dans lequel la récurrence des recalibrages est variable, avec une variabilité indéterminée qui est liée à au moins un paramètre de fonctionnement donné de l'accumulateur.

11. Procédé selon l'une quelconque des revendications 1 à 10, dans lequel les données de diagnostic sont basées, en outre, sur des données physiques additionnelles qui sont issues de surveillances, effectuées *in situ* ou *ex situ,* d'autres accumulateurs du même type que l'accumulateur considéré.

12. Procédé selon l'une quelconque des revendications 1 à 11, comprenant en outre, après l'étape c), une étape (35) de comparaison des données de diagnostic avec de nouvelles données de diagnostic obtenues en utilisant la ou les cartographies recalibrées à l'étape c) pour, en cas de persistance d'un écart entre une valeur représentative de l'état de santé (*ΔQ_{pronostic}*) de l'accumulateur estimée à partir des données de pronostic et une valeur représentative de l'état de santé réel (*ΔQ_{diagnostic}*) de l'accumulateur fondée sur les valeurs de diagnostic, décider le recalibrage d'autres tables paramétriques et/ou de renouveler le recalibrage de la ou des tables paramétriques sur la base de données de surveillance plus étendues, comprenant des données additionnelles fondées sur l'observation d'autres accumulateurs du même type que l'accumulateur considéré.

13. Dispositif de prédiction de l'état de santé d'un accumulateur d'énergie électrique, comprenant des moyens pour la mise en œuvre de toutes les étapes d'un procédé selon l'une quelconque des revendications 1 à 12.

14. Installation de stockage d'énergie électrique comprenant une batterie (2) d'accumulateurs électriques ayant une pluralité d'accumulateurs d'énergie électrique (*2₁*-2*ₘ*) et un dispositif (3) de gestion de la batterie comprenant un dispositif de prédiction de l'état de santé d'un accumulateur d'énergie électrique selon la revendication 13.

15. Produit programme d'ordinateur comprenant des instructions qui, lorsque le programme est chargé dans la mémoire et exécuté par un calculateur d'un ordinateur, met en œuvre toutes les étapes du procédé selon l'une quelconque des revendications 1 à 12.

## Patentansprüche

1. Verfahren zur Vorhersage des Zustands eines Akkumulators zur Speicherung elektrischer Energie, insbesondere einer Lithium-Ionen-Batterie, umfassend die folgenden Schritte, die während des Betriebs des Akkumulators unter realen Einsatzbedingungen im Fled durchgeführt werden:
a) Simulation (32) der Kapazitätsabnahme des Akkumulators, um Prognosedaten zum Zustand des Akkumulators auf der Grundlage physikalischer Daten zu erzeugen, die aus der Überwachung (31) des Akkumulatorbetriebs im Feld während eines bestimmten Überwachungszeitraums stammen, unter Verwendung eines Ausdauermodells, das die prognostizierte Entwicklung der Speichersfähigkeit des Akkumulators in Abhängigkeit von der verstrichenen Zeit und/oder der Nutzung des Akkumulators seit seiner Inbetriebnahme im Feld berücksichtigt, wobei das genannte Modell durch Werte bestimmt wird, die in einer oder mehreren Parametertabellen ([Jcal], [Acal], [Jcyc], [Acyc]), die durch Werte von p-Tupeln von Betriebsparametern des Akkumulators indiziert sind und aus zuvor im Labor durchgeführten Charakterisierungen des Akkumulators stammen;
b) Erstellung (31) von Diagnosedaten zum tatsächlichen Zustand des Akkumulators auf der Grundlage der physikalischen Daten, die aus der Überwachung (31) des Akkumulatorbetriebs im Feld während des Überwachungszeitraums stammen; und,
c) Neukalibrierung (33,34) mindestens einer der Parametertabellen am Ende des betrachteten Überwachungszeitraums, wobei nur ein Teil der Werte dieser Parametertabelle ersetzt wird, wobei die ersetzten Werte die Werte ({Jcal,}i,a; {Jcyc,}i,b), die durch die p-Tupel von Betriebsparametern indiziert sind, unter denen der Akkumulator während des betrachteten Überwachungszeitraums mindestens einmal betrieben wurde, wenn eine Abweichung zwischen einem Wert, der den Gesundheitszustand (ΔQpronostic) des Akkumulators, der anhand der Prognosedaten geschätzt wurde, und einem Wert, der den tatsächlichen Zustand (ΔQdiagnostic) des Akkumulators auf der Grundlage der Diagnosewerte repräsentiert, festgestellt wird, um eine neu kalibrierte Version der Parametertabelle zu erzeugen.

2. Verfahren nach Anspruch 1, wobei das Ausdauer-Modell mindestens zwei Parametertabellen ([Jcal]; [Jcyc]) umfasst, von denen eine erste Parametertabelle ([Jcal]) Werte enthält, die die Geschwindigkeit der Kapazitätsabnahme des Akkumulators im Kalendermodus wiedergeben, und von denen eine zweite Parametertabelle ([Jcyc]) Werte enthält, die die Geschwindigkeit der Kapazitätsabnahme des Akkumulators im Zyklierungsmodus wiedergeben, wobei die erste und/oder die zweite der genannten parametrischen Tabellen in Schritt c) neu kalibriert wird.

3. Verfahren nach Anspruch 2, wobei die erste und/oder die zweite der genannten parametrischen Tabellen im Schritt c) durch Berechnung neu kalibriert werden, indem die zu ersetzenden Werte ({Jcal,}i,a; {Jcyc,}i,b) mit einem Neukalibrierungskoeffizienten (α) multipliziert werden.

4. Verfahren nach Anspruch 3, wobei der Neukalibrierungskoeffizient für alle ersetzten Werte in einer der ersten und zweiten neu kalibrierten Tabellen identisch ist und gegebenenfalls auch für das Ersetzen von Werten in der ersten und der zweiten der genannten neu kalibrierten Parametertabellen identisch ist.

5. Verfahren nach einem der Ansprüche 2 bis 4, wobei der Neukalibrierungskoeffizient (α) eine skalare Zahl ist, die als Verhältnis des auf den Diagnosewerten basierenden, den tatsächlichen Zustand (ΔQdiagnostic) des Akkumulators repräsentierenden Werts zum aus den Prognosedaten geschätzten, den Zustand (ΔQpronostic) des Akkumulators repräsentierenden Wert berechnet wird.

6. Verfahren nach einem der Ansprüche 2 bis 5, wobei das Ausdauer-Modell ferner zwei weitere parametrische Tabellen ([Acal]; [Acyc]), von denen eine dritte Parametertabelle ([Acal]) Werte enthält, die den Formfaktor der kalendarischen Kapazitätsabnahme des Akkumulators berücksichtigen, und von denen eine vierte Parametertabelle ([Acyc]) Werte enthält, die den Formfaktor des zyklusbedingten Kapazitätsabfalls des Akkumulators berücksichtigen, wobei die dritte und/oder die vierte der genannten parametrischen Tabellen in Schritt c) durch ein Optimierungsverfahren neu kalibriert werden, das darauf ausgelegt ist, die Abweichung zwischen den Diagnosedaten und den Prognosedaten zu minimieren.

7. Verfahren nach einem der Ansprüche 1 bis 6, wobei die Neukalibrierung einer Parametertabelle zur Erzeugung einer neu kalibrierten Parametertabelle in Schritt c) das Ersetzen umfasst, nicht nur der Werte ({Jcal,}i,a; {Jcyc,}i, b) indiziert durch die p-Tupel von Betriebsparametern des Akkumulators, bei denen der Akkumulator während des Beobachtungszeitraums mindestens einmal verwendet wurde, sondern auch der Werte der Parametertabelle, die an die genannten, durch die p-Tupel von Betriebsparametern des Akkumulators indizierten Werte angrenzen, unter Verwendung einer bestimmten Glättungsfunktion umfasst.

8. Verfahren nach einem der Ansprüche 1 bis 7, wobei die Neukalibrierung einer Parametertabelle zur Erzeugung einer neu kalibrierten Parametertabelle in Schritt c) nur dann durchgeführt wird, wenn der Wert des Neukalibrierungskoeffizienten (α) um einen Differenzwert von der Einheit abweicht, der größer ist als ein bestimmter Schwellenwert (αth).

9. Verfahren nach einem der Ansprüche 1 bis 8, bei dem die Schritte a) bis c) nach Ablauf jeweils aufeinanderfolgender Überwachungszeiträume iterativ mit fester oder variabler Wiederholungshäufigkeit wiederholt werden.

10. Verfahren nach Anspruch 9, wobei die Häufigkeit der Neukalibrierungen variabel ist, mit einer unbestimmten Variabilität, die mit mindestens einem bestimmten Betriebsparameter des Akkumulators zusammenhängt.

11. Verfahren nach einem der Ansprüche 1 bis 10, bei dem die Diagnosedaten darüber hinaus auf zusätzlichen physikalischen Daten basieren, die aus in situ oder ex situ durchgeführten Überwachungen anderer Akkumulatoren desselben Typs wie der betrachtete Akkumulator stammen.

12. Verfahren nach einem der Ansprüche 1 bis 11, das nach Schritt c) ferner umfasst: einen Schritt (35) zum Vergleich der Diagnosedaten mit neuen Diagnosedaten, die unter Verwendung der in Schritt c) neu kalibrierten Kennfelder ermittelt wurden, um im Falle einer anhaltenden Abweichung zwischen einem aus den Prognosedaten geschätzten Wert, der den Gesundheitszustand (ΔQprognostisch) des Akkumulators repräsentiert, und einem Wert, der den tatsächlichen Gesundheitszustand (ΔQdiagnostic) des Akkumulators, der auf den Diagnosedaten basiert, zu entscheiden, ob weitere Parametertabellen neu kalibriert werden sollen und/oder die Neukalibrierung der Parametertabelle(n) auf der Grundlage umfassenderer Überwachungsdaten, einschließlich zusätzlicher Daten, die auf der Beobachtung anderer Akkumulatoren desselben Typs wie der betrachtete Akkumulator beruhen, wiederholt werden soll.

13. Vorrichtung zur Vorhersage des Zustands eines elektrischen Leistungsakkumulators, umfassend Mitteln zur Durchführung aller Schritte eines Verfahrens gemäß einem der Ansprüche 1 bis 12.

14. Anlage zur Speicherung elektrischer Energie, umfassend eine Batterie (2) aus elektrischen Akkumulatoren mit einer Vielzahl von elektrischen Energieakkumulatoren (21-2m) und eine Batteriemanagementvorrichtung (3) mit einer Vorrichtung zur Vorhersage des Zustands eines elektrischen Energieakkumulators gemäß Anspruch 13.

15. Computerprogrammprodukt, das Befehle umfasst, die, wenn das Programm in den Speicher geladen und von einer Recheneinheit eines Computers ausgeführt wird, alle Schritte des Verfahrens gemäß einem der Ansprüche 1 bis 12 ausführen.

## Claims

1. A method for predicting the state of health of an electrical energy storage device, in particular a lithium-ion battery, comprising the following steps, performed during the operation of the storage device under real-world field conditions:
a) simulating (32) the degradation of the battery's capacity to generate predictive data on the battery's state of health based on physical data obtained from monitoring (31) the battery's operation in the field over a specified monitoring period, using a durability model that accounts for the projected evolution of the battery's performance as a function of elapsed time and/or battery usage since its introduction into service in the field, said model being determined by values stored in one or more parametric tables ([Jcal], [Acal], [Jcyc], [Acyc]) that are indexed by values of p-tuples of battery operating parameters and that are derived from battery characterizations previously performed in laboratory conditions;
b) generating (31) diagnostic data regarding the actual state of health of the battery, based on physical data obtained from monitoring (31) the battery's operation in the field during the monitoring period; and,
c) recalibrating (33, 34) at least one of the parameter tables at the end of the monitoring period considered, by replacing only a portion of the values in said parameter table, the replaced values including the values ({Jcal,}i,a; {Jcyc,}i,b) indexed by the p-tuples of operating parameters under which the battery operated at least once during the monitoring period considered, when a discrepancy exists between a value representing the health status (ΔQpronostic) of the battery estimated from the prognostic data and a value representative of the actual state of health (ΔQdiagnostic) of the battery based on the diagnostic values is detected, in order to produce a recalibrated version of the parametric table.

2. A method as claimed in claim 1, wherein the durability model comprises at least two parametric tables ([Jcal]; [Jcyc]), a first parametric table ([Jcal]) of which contains values reflecting the rate of degradation of the battery's capacity in calendar mode, and a second parametric table ([Jcyc]) contains values reflecting the rate of degradation of the battery's capacity in cycling mode, one and/or both of said first and second parametric tables being recalibrated in step c).

3. A method as claimed in claim 2, wherein A method as claimed in claim 9, wherein the frequency of recalibrations is variable, with an indeterminate variability that is related to at least one given operating parameter of the battery. one and/or both of said first and second parametric tables are recalibrated in step c) by calculation, by multiplying the values to be replaced ({Jcal,}i,a; {Jcyc,}i,b) by a recalibration coefficient (α).

4. A method as claimed in claim 3, wherein the recalibration coefficient is the same for all values replaced in one of the recalibrated tables among the first and second tables, and is also the same, if applicable, for the replacement of values in both of said first and second recalibrated parametric tables.

5. A method as claimed in any one of claims 2 through 4, wherein the recalibration coefficient (α) is a scalar number calculated as the ratio of the value representative of the actual state of health (ΔQdiagnostic) of the battery, based on the diagnostic values, to the value representative of the health status (ΔQpronostic) of the battery, estimated from the prognostic data.

6. A method as claimed in any one of claims 2 through 5, wherein the durability model further comprises two additional parametric tables ([Acal]; [Acyc]), one of which, a third parametric table ([Acal]), contains values reflecting the rate of calendar-mode degradation of the battery's capacity, and one of which, a fourth parametric table ([Acyc]) contains values representing the shape factor of the battery capacity degradation due to cycling, one and/or both of said third and fourth parametric tables being recalibrated, in step c), by an optimization method adapted to minimize the discrepancy between the diagnostic data and the prognostic data.

7. A method as claimed in any one of claims 1 through 6, wherein recalibrating a parameter table to produce a recalibrated parameter table in step c) comprises replacing not only the values ({Jcal,}i,a; {Jcyc,}i, b) indexed by the p-tuples of battery operating parameters under which the battery was used at least once during the observation period, but also replacing the values in the parameter table that are adjacent to said values indexed by said p-tuples of battery operating parameters, using a given smoothing function.

8. A method as claimed in any one of claims 1 through 7, wherein recalibration of a parametric table to produce a recalibrated parametric table is performed, in step c), only if the value of the recalibration coefficient (α) differs from unity by a difference greater than a predetermined threshold value (αth).

9. A method as claimed in any one of claims 1 through 8, wherein steps a) through c) are repeated iteratively, with a fixed or variable recurrence, at the end of successive monitoring periods.

10. A method as claimed in claim 9, wherein the frequency of recalibrations is variable, with an indeterminate variability that is related to at least one given operating parameter of the battery.

11. A method as claimed in any one of claims 1 through 10, wherein the diagnostic data is further based on additional physical data derived from in situ or ex situ monitoring of other batteries of the same type as the battery considered.

12. A method as claimed in any one of claims 1 through 11, further comprising, after step c), a step (35) of comparing the diagnostic data with new diagnostic data obtained using the one or more tables recalibrated in step c) to, in the event that a discrepancy persists between a value representative of the state of health (ΔQprognosis) of the battery estimated from the prognostic data and a value representative of the actual state of health (ΔQdiagnostic) of the battery based on the diagnostic values, decide to recalibrate other parametric tables and/or to recalibrate the parametric table(s) again based on more extensive monitoring data, including additional data derived from the observation of other batteries of the same type as the battery considered.

13. A device for predicting the state of health of an electrical energy storage device, comprising means for carrying out all the steps of a method as claimed in any one of claims 1 through 12.

14. An electrical energy storage system comprising a battery (2) of electrical energy storage devices having a plurality of electrical energy storage devices (21-2m) and a battery management device (3) comprising a device for predicting the state of health of an electrical energy storage device according to claim 13.

15. A computer program product comprising instructions that, when the program is loaded into memory and executed by a processor of a computer, perform all the steps of the method as claimed in any one of claims 1 through 12.
